# EUROPÄISCHE PATENTANMELDUNG

(11) **EP 2 568 391 A2**
(43) Veröffentlichungstag der Anmeldung: **13.03.2013**
(21) Anmeldenummer: 12006241.9
(22) Anmeldetag: 04.09.2012
(51) Int. Cl.: G06F 13/42

(54) **Modul, System aufweisend ein derartiges Modul sowie Verfahren zur Vergabe von Parallelbus-Adressen**

(30) Priorität: 09.09.2011 DE 102011053471
(71) Anmelder: Minimax GmbH & Co KG, 23840 Bad Oldesloe (DE)
(72) Erfinder: Jürgen, Gottwald, 23843 Neritz (DE); Hartwig, Steffen, 21465 Reinbek (DE)

(57) **Zusammenfassung**

Die Erfindung betrifft ein Modul (2) mit einem Schnellbefestigungsmittel zur Befestigung des Moduls (2) auf einer Modulaufnahme, einer Parallelbus-Schnittstelle (4) zum Senden und/oder Empfangen von Daten, Adressen und/oder Steuersignalen und mit einer Sclektions-Schnittstelle (6), wobei die Selaktions-Schnittstelle (6) einen Sender (8) zum Senden eines Selektionssignals und/oder einen Empfänger (10) zum Empfang eines Selektionssignals aufweist, wobei das Schnellbefestigungsmittel an der Bodenwand (12) des Moduls (2) angeordnet ist, und wobei die Seitenwände (14) vorsprungsfrei ausgestaltet sind. Außerdem betrifft die Erfindung ein System mit mindestens einem derartigen Modul sowie ein entsprechend angepasstes Verfahren zur Vergabe von Parallelbus-Adressen an derartige Module.

## Beschreibung

Die Erfindung betrifft ein Modul mit einem Schnellbefestigungsmittel zur Befestigung des Moduls auf einer Modulaufnahme, einer Parallelbus-Schnittstelle zum Senden und/oder Empfangen von Daten, Adressen und/oder Steuersignalen und mit einer Selektions-Schnittstelle, wobei die Selektions-Schnittstelte einen Sender zum Senden eines Selektionssignals und/oder einen Empfänger zum Empfangen eines Selektionssignals aufweist, wobei das Schnellbefestigungsmittel an der Bodenwand des Moduls angeordnet ist.

Außerdem betrifft die Erfindung ein System mit einer Modulaufnahme, einem Parallelbus, einer Steuerungseinheit, der eine Parallelbus-Schnittstelle zum Senden und/oder Empfangen von Daten, Adressen und/oder Steuersignalen zugeordnet ist, wobei die Parallelbus-Schnittstelle der Steuerungseinheit mit dem Parallelbus verbunden ist, und mindestens einem Modul in Signalverbindung mit der Steuerungseinheit.

Darüber hinaus betrifft die Erfindung ein Verfähren zur Vergabe von Parallelbus-Adressen von einer Steuerungseinheit an Module, wobei der Steuerungseinheit eine Parallelbus-Schnittstelle zum Senden und/oder Empfangen von Daten, Adressen und/oder Steuersignalen zugeordnet ist, und wobei jedes Modul eine Parallelbus-Schnittstelle zum Senden und/oder Empfangen von Daten, Adressen und/oder Steuersignalen und eine Selektions-Schnittstelle mit einem Sender zum Senden eines Selektionssignals und/oder einem Empfänger zum Empfangen eines Selektionssignals aufweist.

Module der eingangs genannten Art oder Systeme mit derartigen Modulen sind aus dem Stand der Technik bekannt. Derartige Module werden typischerweise auf die Modulaufnahme, insbesondere eine Trägerschiene oder eine Hutschiene, aufgesetzt und mit dem Parallelbus verbunden. Die Parallelbus-Schnittstelle ist deshalb bevorzugt eine Einheit zum Anschluss an einen Parallelbus. Ein entsprechendes Anschlussmittel kann vorgesehen sein. Die Modulaufnahme und/oder der Parallelbus können elektrische Energieversorgungsleitungen aufweisen, die zur Strom- und/oder Energieversorgung der verbundenen Module und/oder der Steuerungseinheit dienen können. Des Weiteren ist die Parallelbus-Schnittstelle des Moduls bevorzugt in der Weise angeordnet und/oder ausgestaltet, dass diese sich beim Aufsetzten auf die Modulaufnahme mit dem Parallelbus verbindet. In einer besonders vorteilhaften Ausgestaltung ist der Parallelbus integraler Bestandteil der Modulaufnahme. Außerdem ist eine Parallelbus-Schnittstelle des Moduls bevorzugt an der Bodenwand des Moduls angeordnet, so dass sich die Parallelbus-Schnittstelle des Moduls mit dem Parallelbus beim Aufsetzen des Moduls auf die Modulaufnahme verbindet. Das Modul kann somit mit einem Parallelbus verbunden sein. Analog zu dem Modul sind auch entsprechende Ausgestaltungen für eine Steuerungseinheit bekannt. Eine Parallelbus-Schnittstelle des Moduls und/oder der Steuerungseinheit kann an den Parallelbus angepasste Kontaktmittel aufweisen, um eine entsprechende Busverbindung mit dem Parallelbus herstellen zu können. Entsprechende Kontaktmittel können beispielsweise Kontaktfedern sein. Mit einer Schnittstelle ist deshalb bevorzugt eine Anschlusseinheit gemeint So kann die Parallelbus-Schnittstelle auch als Parallelbus-Anschlusseinheit bezeichnet sein. Entsprechendes gilt für die Selektions-Schnittstelle, die auch als Selektions-Anschlusseinheit bezeichnet werden kann.

Der Parallelbus kann eine oder eine Mehrzahl von Busleitungen in Form von insbesondere langgestreckten, elektrischen Leitern oder einer Leiterplatte mit Leiterbahnen aufweisen. In der Praxis werden oftmals zwei Busleitungen bei einer seriellen Datenübertragung und 2^{N} mit N>2 , also beispielsweise 8,16, 32 oder 64 Parallelbusleitungen bei einer parallelen Datenübertragung verwendet. Die Busleitungen können in einer beliebigen Länge hergestellt und/oder an die jeweilige Anwendung in ihrer Länge angepasst sein. Die Busleitungen können an der Modulaufnahme, insbesondere lösbar, befestigt sein. Die Modulaufnahme und/oder der Parallelbus kann des Weiteren ein Leitungssystem zur Energieübertragung aufweisen. Der Begriff "Parallelbus" spiegelt deshalb insbesondere die physikalische Betrachtung wider. Außerdem ist es bevorzugt vorgesehen, dass der Parallelbus zum parallelen und/oder gleichzeitigen übertragen von Daten, Adressen und/oder Steuersignalen eingerichtet und ausgestaltet ist. Mehrere Module und/oder Steuerungseinheiten können mittels ihrer jeweiligen Parallelbus-Schnittstelle Daten, Adressen und/oder Steuersignale parallel bzw. gleichzeitig senden und/oder empfangen.

Ein Parallelbus sowie die gattungsgemäße Kommunikation mittels eines Parallelbusses sind in vielfältiger Weise aus dem Stand der Technik bekannt. Eine entsprechende Parallelbus-Schnittstelle eignet sich somit zum Senden und/oder Empfangen von Daten, Adressen und/oder Steuersignalen. Zum Aufbau eines Parallelbussystems können mehrere Parallelbus-Schnittstellen jeweils parallel an einen Parallelbus angeschlossen werden. Wenn eine Mehrzahl von Parallelbus-Schnittstellen parallel an einen gemeinsamen Parallelbus angeschlossen ist, erfolgt die Kommunikation zumeist über bestimmte Zugriffsverfahren (Protokolle). Das aus dem Stand der Technik bekannte Controller Area Network (CAN) kann eine Mehrzahl von Komponenten, jeweils mit einer Parallelbus-Schnittstelle, mittels eines Parallelbusses mit, insbesondere zwei, Busleitungen miteinander verbinden. Da die Module als beliebige Funktionsmodule und/oder Peripheriemodule ausgestaltet sein können und/oder eine Verbindung zu einem Sensor oder einem Stellglied aufweisen können, wird in der Praxis zweckmäßigerweise festgelegt, welches der Module was und/oder wann senden und/oder empfangen kann, Hierfür gibt es die bereits erwähnten Übertragungsverfahren und/oder Protokolle. Ein Parallelbussystem ist oftmals so organisiert, dass zu einem bestimmten Zeitpunkt eine Steuerungseinheit Daten oder Steuersignale mittels ihrer Parallelbus-Schnittstelle und dem damit verbundenen Parallelbus sendet. Zumeist sollen die gesendeten Daten und/oder Steuersignale zu einem bestimmten Modul transportiert und von diesem weiterverarbeitet werden. Es ist aber auch möglich, dass die Daten und/oder Steuersignale von mehreren Modulen empfangen und weiterverarbeitet werden sollen. Um festzulegen, welches Modul oder welche Module die Daten oder Steuersignale empfangen und/oder weiterverarbeiten sollen, wird zumeist eine Adressierung der Module vorgenommen. Aus dem Stand der Technik sind deshalb Module mit einer Kodier-Schalteranordnung bekannt, mittels der jeweils die Parallelbus-Adresse eines Moduls einstellbar und/oder bestimmbar ist. Eine Parallelbusadresse dient der gezielten Kommunikation auf dem Parallelbus zwischen einer Steuerungseinheit und den Modulen oder zwischen den Modulen selbst. Die Parallelbusadresse ist also eine Adresse von einem Modul beziehungsweise von einer Steuerungseinheit. Bevorzugt sind die Parallelbusadressen eindeutig. Anhand der eingestellten Adresse können die Module dann jeweils unabhängig voneinander entscheiden, ob die gesendeten Daten und/oder Steuersignale für sie bestimmt sind. Denn vor dem Senden der Daten und/oder Steuersignale und/oder mit dem Senden der Daten und/oder Steuersignale wird eine Adresse versendet, die angibt, an welches Modul und/oder an welche Module die Daten und/oder Steuersignale transportiert werden sollen.

Die händische Einstellung einer Parallelbus-Adresse eines Moduls mittels einer Kodier-Schalteranordnung zeigt in der Praxis eine sehr hohe Fehlerrate. Eine Weiterentwicklung aus dem Stand der Technik sieht deshalb Module mit jeweils einer Selektions-Schnittstelle vor, wobei die jeweilige Selektions-Schnittstelle ein gegenüber der Seitenwand des Moduls hervorspringendes Senderanschlussmittel eines Senders zum Senden eines Selektionssignals aufweist Werden mehrere Module nebeneinander angeordnet, so können die jeweiligen Selektions-Schnittstellen in der Art galvanisch miteinander verbunden werden, dass ein Senderanschlussmittel eines der Module in eine Ausnehmung einer Seitenwand eines weiteren Moduls einfasst, wobei diese Ausnehmung ein Empfängeranschlussmittel eines Empfängers der entsprechenden Selektions-Schnittstelle aufweist und diese Empfängerschnittstelle galvanisch mit der Senderanschlussstelle verbunden wird. Um eine entsprechende Verbindung zwischen zwei Selektions-Schnittstellen herzustellen, werden zwei Module auf eine gemeinsame Modulaufnahme voneinander beabstandet aufgesteckt und daraufhin so aufeinander zusammengeschoben, dass das Senderanschlussmittel des einen Moduls in die Seitenwand des anderen Moduls hineinfasst, um hier die zuvor genannte galvanische Verbindung zwischen dem Senderanschlussmittel und dem Empfängeranschlussmittel herzustellen.

Bevorzugt ist die Selektions-Schnittstelle zum Aufbau jeweils einer Signalverbindung zu benachbarten Selektions-Schnittstellen eingerichtet und/oder ausgebildet. Damit sind physikalisch Punkt-zu-Punkt-Verbindungen möglich. Mittels der Selektions-Schnittstelle kann somit ein Selektionssignal von einer Steuerungseinheit an ein Modul und/oder von einem Modul zu einem Modul transportiert werden. Das Selektionssignal ist dabei ein Signal zum Aktivieren eines Adressierungsmodus des Moduls. In dem Adressierungsmodus kann das Modul eine Parallelbus-Adresse, insbesondere mittels der zugehörigen Parallelbus-Schnittstelle, empfangen und diese als ihre Parallelbus-Adresse zum Adressieren speichern, Hat ein Modul die empfangene Parallelbus-Adresse als ihre Parallelbus-Adresse gespeichert, so ist es möglich, dass dieses Modul das Selektionssignal an ein benachbartes Modul weitersendet. Damit ist eine besonders einfache und sichere Vergabe von Parallelbus-Adressen an Module möglich,

In der Praxis werden derartige Module oftmals für Brandfallzentralen verwendet, um eine Datenkommunikation zu und/oder eine Steuerung von einer Vielzahl von Sensoren und/oder Aktuatoren zu gewährleisten. Dabei ist es für gewöhnlich vorgesehen, dass die Brandfallzentrale eine oder mehrere Brandmelderzentralen, Löschsteuerungszentralen, elektrische Steuereinrichtungen zur Ansteuerung von Gaslöschanlagen und/oder Gefahrenmeldezentralen umfasst bzw. diese bildet. Eine schnelle Ausbreitung von einer Gefahrensituation, wie beispielsweise einem Brand oder einem toxischen Gas, stellt hohe Anforderungen an die Module bzw. an die Brandfallzentrale. So muss beispielsweise eine Detektion möglichst schnell und zuverlässig erfolgen. Entsprechendes gilt für die Bekämpfung. Um die Module und/oder die Brandfallzentrale über einen längeren Zeitraum zumindest im Wesentlichen störungsfrei zu betreiben, ist neben einer intelligenten Fehlererkennung auch eine einfache Austauschbarkeit eines Moduls, vorzugsweise der Brandfallzentrale, von erheblicher Bedeutung.

Der Erfindung liegt deshalb die Aufgabe zugrunde, ein Modul, ein System aufweisend ein derartiges Modul sowie ein Verfahren zur Vergabe von Parallelbus-Adressen zu schaffen, die jeweils eine einfache und sichere Installation und/oder Instandhaltung von mehreren, nebeneinander angeordneten Modulen ermöglichen.

Die Aufgabe wird durch ein Modul der eingangs genannten Art dadurch gelöst, dass die Seitenwände vorsprungsfrei ausgestaltet sind. Bereits zuvor wurde die Bodenwand des Moduls eingeführt, an der das Schnellbefestigungsmittel angeordnet ist. Auf der Bodenwand des Moduls stehen für gewöhnlich eine Vorderwand, eine Rückwand und zwei Seitenwände. Unter den Seitenwänden können also die Wände des Moduls verstanden werden, die seitlich auf der Bodenwand des Moduls stehen. Mit anderen Worten: Mit den Seitenwänden sind bevorzugt die auf der Bodenwand stehenden, gegenüberliegend angeordneten Wände (oder mindestens eine Wand) gemeint, die dazu eingerichtet und/oder ausgebildet sind, um jeweils ein weiteres Modul zumindest im Wesentlichen spaltfrei daran angrenzend anzuordnen. Die Seitenwände können also die Anlageseiten des Moduls sein. Dank der vorsprungsfreien Ausgestaltung der Seitenwände des Moduls können mehrere Module besonders einfach und sicher nebeneinander angeordnet werden, Denn die erfindungsgemäßen Module weisen an ihren Seitenwänden keine Vorsprünge auf. Damit kann ein Modul nach dem Anderen direkt nebeneinander auf einer Modulaufnahme befestigt werden, ohne dass die Module seitlich ineinander verhaken. Mit anderen Worten können die Module jeweils mechanisch unabhängig voneinander auf einer Modulaufnahme befestigt werden oder sein. Die Verbindung zwischen zwei Modulen kann somit formschlussfrei, also frei von einem direkten Formschluss zwischen benachbarten Modulen, sein. Mehrere, nebeneinander angeordnete Module können deshalb auch besonders einfach und sicher gewartet oder instand gehalten werden. Denn jedes Modul kann für sich problemlos aus einer derartigen Anordnung herausgezogen oder hereingesteckt werden. Die vorsprungsfreie Ausgestaltung der Seitenwände verhindert hierbei, dass sich benachbarte Seitenwände ineinander verhaken oder verkeilen. Ist beispielsweise ein in der Mitte von zwei weiteren Modulen angeordnetes Modul defekt, kann dieses problemlos aus einer derartigen Anordnung herausgezogen werden und durch ein störungsfreies, beispielsweise durch ein neues entsprechendes Modul ersetzt werden. Eine derartige Wartungsroutine kann innerhalb kürzester Zeit erfolgen, ohne Einfluss auf benachbarte Module nehmen zu müssen. Die für Brandfallzentralen erforderliche Betriebssicherheit kann somit besonders effizient gewährleistet werden.

Eine vorteilhafte Ausgestaltung der Erfindung zeichnet sich dadurch aus, dass die Selektions-Schnittstelle eine drahtlose Schnittstelle ist. Dank dieser Ausgestaltung ist die Selektions-Schnittstelle zum drahtlosen Senden und/oder Empfangen eines Selektionssignals ausgestaltet. Zum Übertragen eines Selektionssignals von einem Sender zu einem Empfänger sind somit keine elektrischen Leiter als Übertragungsmedium notwendig. Eine drahtlose Selektions-Schnittstelle weist deshalb den Vorteil auf, dass neben dem Modul keine weitere Einrichtung für die Kommunikation des Selektionssignals, insbesondere fest installiert, bereitgehalten werden muss. Damit kann auf spezielle Übertragungsleitungen zur Übertragung des Selektionssignals verzichtet werden. Mehrere nebeneinander angeordnete Module, jeweils mit einer drahtlosen Selektions-Schnittstelle, können das Selektionssignal nacheinander von Modul zu Modul übertragen. Eine drahtlos ausgestaltete Selektions-Schnittstelle kann besonders flexibel und/oder komfortabel installiert und/oder gewartet werden.

Eine weitere vorteilhafte Ausgestaltung der Erfindung zeichnet sich dadurch aus, dass der Sender der Selektions-Schnittstelle vorsprungsfrei an einer Seitenwand des Moduls angeordnet ist, und/oder dass der Empfänger der Selektions-Schnittstelle vorsprungsfrei an einer, insbesondere weiteren, Seitenwand des Moduls angeordnet ist. Mit "an einer Seitenwand" ist bevorzugt der von dem Modul umfasste Bereich in der Nähe von der jeweiligen Seitenwand und/oder der Seitenwand selbst gemeint. Somit kann zumindest ein Teil des Senders und/oder ein Teil des Empfängers ein integraler Teil der jeweiligen Seitenwand sein. Außerdem ist es möglich, dass der Sender und/oder der Empfänger von der jeweiligen Seitenwand beabstandet ist, wobei der jeweilige Abstand so gewählt ist, dass die jeweilige Funktion gewährleistet ist. In einer zweckmäßigen Ausgestaltung ist der Sender und/oder der Empfänger von der jeweiligen Seitenwand maximal ein Zentimeter beabstandet. In diesem Fall ist sichergestellt, dass der Sender und/oder der Empfänger jeweils vorsprungsfrei an der jeweiligen Seitenwand angeordnet sind. Mit "vorsprungsfrei" ist deshalb bevorzugt gemeint, dass der Sender und/oder der Empfänger, zumindest im Wesentlichen, nicht über die jeweilige Seitenwand hinausragen. Dank dieser Ausgestaltung ist sowohl eine zuverlässige Kommunikation mittels der Selektions-Schnittstelle als auch eine sichere und komfortable Installation und/oder Wartung des jeweiligen Moduls gewährleistet.

Eine von der zuletzt erläuterten, abweichenden Ausgestaltung der Erfindung sieht vor, dass der Sender und/oder der Empfänger der Selektions-Schnittstelle an der Bodenwand des Moduls angeordnet sind. Der Wortlaut "an der Bodenwand" ist in analoger Weise zu dem zuvor erläuterten Wortlaut "an der Seitenwand" zu verstehen, wobei in diesem Fall die "Seitenwand" durch die "Bodenwand" zu ersetzten ist. Somit können der Sender und/oder der Empfänger der Selektions-Schnittstelle an der Bodenwand des Moduls angeordnet sein. Zwar ist es bevorzugt, dass der Sender und/oder der Empfänger auch vorsprungsfrei an der Bodenwand angeordnet sind, jedoch ist dies keine notwendige Voraussetzung. So kann ein Teil des Senders und/oder ein Teil des Empfängers gegenüber der Bodenwand hervorspringen. Dank der bevorzugten Anordnung der Selektions-Schnittstelle bzw. deren Sender und/oder Empfänger an der Bodenwand des Moduls können die Seitenwände des Moduls unabhängig oder einflussfrei von der Selektions-Schnittstelle ausgestaltet sein. Diese Weiterbildung dient deshalb auch der vorsprungsfreien Ausgestaltung der Seitenwände und der damit einhergehenden Vorteile gegenüber dem Stand der Technik.

Eine weitere vorteilhafte Ausgestaltung der Erfindung sieht vor, dass die Parallelbus-Schnittstelle an der Bodenwand des Moduls angeordnet ist. Auch hier gilt, dass unter dem Begriff "an der Bodenwand" bevorzugt zu verstehen ist, dass die Parallelbus-Schnittstelle in der Nähe zu der Bodenwand des Moduls angeordnet ist. Die Parallelbus-Schnittstelle kann zumindest teilweise integraler Bestandteil der Bodenwand sein. Auch ist es möglich, dass ein Teil der Parallelbus-Schnittstelle gegenüber der Bodenwand hervorspringt oder nach innen versetzt angeordnet ist. Auch dank dieser Ausgestaltung ist es möglich, dass die Seitenwände vorsprungsfrei ausgestaltet sind. Auf entsprechend zuvor genannte Vorteile wird an dieser Stelle Bezug genommen.

Eine weitere vorteilhafte Ausgestaltung der Erfindung zeichnet sich dadurch aus, dass eine Wirkrichtung des Senders und eine Empfangsrichtung des Empfängers korrespondierend zueinander ausgestaltet und/oder ausgerichtet sind. Damit ist es möglich, dass der Empfänger eines Moduls ein Selektionssignal eines Senders eines weiteren Moduls empfangen kann. Die Wirkrichtung ist bevorzugt die Richtung, in der der entsprechende Sender das Selektionssignal aussendet. Die Empfangsrichtung des Empfängers ist bevorzugt die Richtung, aus der der Empfänger ein Selektionssignal empfangen kann. Wird von dem Sender ein Selektionssignal in einer Wirkrichtung gesendet, die zu der Empfangsrichtung des Empfängers korrespondiert, so kann der Empfänger das Selektionssignal empfangen. Grundsätzlich ist es möglich, dass der Sender eine Vielzahl von Wirkrichtungen und/oder der Empfänger eine Vielzahl von Empfangsrichtungen aufweist. Sendet der Sender nun ein Selektionssignal in einer Wirkrichtung, die zu keiner der insbesondere mehreren möglichen Empfangsrichtungen des Empfängers korrespondiert, so wird der Empfänger das entsprechende Selektionssignal auch nicht empfangen. Durch die vorteilhafte Weiterbildung der Erfindung ist es somit möglich, die Sicherheit einer Übertragung eines Selektionssignals zu gevährleisten oder zu erhöhen. Denn bevorzugt empfängt der Empfänger ein Selektionssignal nur aus der mindestens einen Empfangsrichtung. Signale, die im Sinne dieser vorteilhaften Ausgestaltung aus einer davon abweichenden Richtung und damit sehr wahrscheinlich von einer Störquelle stammen, werden von dem Empfänger nicht empfangen oder mit einer solch niedrigen Signalstärke empfangen, so dass das entsprechende Signal als nicht empfangen bewertet wird. Dank dieser Weiterbildung ist ein sicherer und störungsfreier Betrieb des Moduls und/oder eines damit verbundenen Systems zuverlässig gewährleistet.

Eine weitere vorteilhafte Ausgestaltung der Erfindung zeichnet sich dadurch aus, dass der Sender der Selektions-Schnittstelle eine Lichtquelle, eine induktive Quelle, eine elektromagnetische Quelle, eine akustische Quelle und/oder einen mechanischen Stempel aufweist, und/oder dass der Empfänger der Selektions-Schnittstelle einen optischen Sensor, einen Induktionssensor, einen elektromagnetischen Sensor, einen akustischen Sensor und/oder einen mechanischen Sensor aufweist. Der Sender und der Empfänger der Selektions-Schnittstelle sind bevorzugt korrespondierend zueinander ausgestaltet. Weist der Sender beispielsweise eine Lichtquelle auf, so ist es bevorzugt, dass der Empfänger einen optischen Sensor aufweist. Unter einer Lichtquelle kann eine Einheit verstanden werden, die sichtbares und/oder nicht sichtbares Licht aussenden kann. Unter einem optischen Sensor ist insbesondere ein optoelektronischer Sensor zu verstehen, der eine optische Strahlung, wie Licht, in eine elektrische Energieform umwandeln kann und/oder einen von der einfallenden optischen Strahlung abhängigen elektrischen Widerstand aufweist. Analog zu der Lichtquelle bzw. dem optischen Sensor können auch die übrigen Quellen bzw. Sensoren ausgestaltet sein. Eine induktive Quelle ist bevorzugt eine Einheit, mit der ein Magnetfeld erzeugbar ist. Ein Induktionssensor ist bevorzugt ein Sensor, der ein sich, insbesondere änderndes, elektrisches Magnetfeld in eine elektrische Spannung umwandelt. Eine akustische Quelle ist bevorzugt eine Einheit, die eine Schallwelle abgeben kann. Ein akustischer Sensor ist bevorzugt ein Sensor, der eine Schallwalle empfangen und diese in eine andere Energieform, beispielsweise eine elektrische Energie, umwandeln kann oder einen von der Schallwelle abhängigen elektrischen Widerstand aufweist. Mittels des mechanischen Stempels kann ein Selektionssignal bevorzugt in eine physikalische Bewegung und/oder Druckkraft des Stempels umgewandelt werden. Ein mechanischer Sensor kann die Bewegung, insbesondere des Stempels, aufnehmen. Hierbei kann insbesondere der Weg, die Geschwindigkeit, die Beschleunigung und/oder die Kraft sensorisch aufgenommen Werden. Die genannten vorteilhaften Ausgestaltungen des Senders und/oder des Empfängers gewährleisten, dass die Seitenwände des Moduls vorsprungsfrei ausgestaltet werden können und erlauben gleichzeitig eine flexible und komfortable Übertragung des Selektionssignals.

Eine weitere vorteilhafte Ausgestaltung der Erfindung zeichnet sich dadurch aus, dass der Sender der Selektions-Schnittstelle eine Kodier-Einheit und/oder eine Modulations-Einheit aufweist, und/oder dass der Empfänger der Selektions-Schnittstelle eine Dekodier-Einheit und/oder eine Demodulations-Einheit aufweist. Mittels der Kodier-Einheit kann ein Selektionssignal kodiert werden. Die Dekodier-Einheit ist bevorzugt dazu ausgebildet, dass Selektionssignal zu dekodieren. Damit ist eine besonders sichere Übertragung des Selektionssignals möglich. Mittels der Modulations-Einheit kann das Selektionssignal moduliert werden. Mit der Demodulations-Einheit kann das Selektionssignal entsprechend demoduliert werden. Dank dieser Ausgestaltung ist eine gegenüber Störeinflüssen robuste Übertragung des Selektionssignals möglich. Grundsätzlich ist es möglich, dass das Selektionssignal kodiert und/oder moduliert übertragen wird. Somit kann die Selektions-Schnittstelle sowohl eine Kodier-Einheit und eine Modulations-Einheit aufweisen. Entsprechendes gilt für den Empfänger, der somit sowohl eine Dekodier-Einheit als auch eine Demodulations-Einheit aufweisen kann. In dieser Ausgestaltungsvariante ist die Übertragung sicher als auch robust gegenüber möglichen Störeinflüssen.

Die eingangs genannte Aufgabe wird außerdem durch ein System mit einer Modulaufnahme, einem Parallelbus, einer Steuerungseinheit, der eine Parallelbus-Schnittstelle zum Senden und/oder Empfangen von Daten, Adressen und/oder Steuersignalen zugeordnet ist, wobei die Parallelbus-Schnittstelle der Steuerungseinheit mit dem Parallelbus verbunden ist, und mindestens ein Modul der erfindungsgemäßen Art in Signalverbindung mit der Steuerungseinheit. Die Merkmale und/oder Details, die im Zusammenhang mit dem erfindungsgemäßen Modul zuvor beschrieben worden sind und/oder im Weiteren beschrieben werden, gelten dabei selbstverständlich auch im Zusammenhang mit dem erfindungsgemäßen System und umgekehrt. Soweit es sinnvoll ist, gelten die zuvor genannten Ausführungen der Parallelbus-Schnittstelle des erfindungsgemäßen Moduls und der Selektions-Schnittstelle des Moduls auch für die Parallelbus-Schnittstelle der Steuerungseinheit bzw. für eine optionale Selektions-Schnittstelle der Steuerungseinheit. Denn es kann vorgesehen sein, dass der Steuerungseinheit eine Selektions-Schnittstelle mit einem Sender zum Senden eines Selektionssignals zugeordnet ist. In diesem Zusammenhang wird aber darauf hingewiesen, dass die Selektions-Schnittstelle der Steuerungseinheit bevorzugt keinen Empfänger zum Empfangen eines Selektionssignals auhweist oder dieser zugeordnet ist. Jedoch ist es möglich, dass auch ein erfindungsgemäßes Modul die Steuerungseinheit aufweist und/oder diese bildet. Die Parallelbus-Schnittstelle und/oder die Selektions-Schnittstelle des entsprechenden Moduls können somit der Steuerungseinheit zugeordnet sein. Die Signalverbindung zwischen der Steuerungseinheit und dem mindestens einen Modul kann mittels der jeweiligen Parallelbus-Schnittstelle und dem Parallelbus ausgebildet und/oder aufgebaut sein. Die zuvor erläuterten Vorteile des Moduls gelten somit auch für das System, das eine überraschend einfache sowie sichere Installation und Wartung von mehreren nebeneinander angeordneten Modulen ermöglicht.

Eine vorteilhafte Ausgestaltung des Systems zeichnet sich dadurch aus, dass die Module nacheinander und/oder jeweils aneinander grenzend auf der Modulaufnahme befestigt sind, wobei die Parallelbus-Schnittstellen der Module mit dem Parallelbus verbunden sind. Neben der Steuerungseinheit sind somit auch die Module mit dem Parallelbus verbunden. Somit können mittels des Parallelbusses Daten, Adressen und/oder Steuersignale ausgetauscht werden. Damit die Steuerungseinheit den Modulen gezielt Daten und/oder Steuersignale übertragen kann, hat sich in der Praxis etabliert, den Modulen jeweils eine Parallelbus-Adresse zuzuweisen. Mittels dieser Adresse kann eine zielgerichtete Kommunikation zwischen der Steuerungseinheit und dem jeweiligen zu der Adresse zugehörigen Modul ermöglicht werden. Um die Vergabe der Parallelbus-Adressen zu ermöglichen, weist jedes Modul und bevorzugt auch die Steuerungseinheit eine Selektions-Schnittstelle auf. Mittels des Selektionssignals kann ein Adressierungsmodus eines Moduls aktiviert werden, der es erlaubt, dass die Steuerungseinheit dem entsprechenden Modul mittels des Parallelbusses eine Parallelbus-Adresse überträgt, die das entsprechende Modul als ihre Adresse speichern kann. Ein System mit mindestens einem erfindungsgemäßen Modul gewährleistet somit eine einfache und sichere Installation und/oder Instandhaltung des mindestens einen Moduls als auch des Gesamtsystems.

Eine vorteilhafte Ausgestaltung des Systems zeichnet sich dadurch aus, dass eines der Module seitlich an der Steuerungseinheit grenzend angeordnet ist, wobei der Steuerungseinheit eine Selektions-Schnittstelle mit einem Sender zum Senden eines Selektionssignals zugeordnet ist. Damit ist eine besonders kompakte Ausgestaltung des Systems möglich.

Die Aufgabe der Erfindung wird außerdem durch eine erste Variante des Verfahrens der eingangs genannten Art dadurch gelöst, dass eines der Module als Anfangsmodul mittels der zugehörigen Selektions-Schnittstelle drahtlos ein Selektionssignal zum Aktivieren eines Adressierungsmodus sendet und ein weiteres der Module als Zielmodul mittels der zugehörigen Selektions-Schnittstelle das Selektionssignal zum Aktivieren des Adressierungsmodus drahtlos empfängt. Eine zweite Variante des Verfahrens der eingangs genannten Art löst die Aufgabe der Erfindung dadurch, dass der Steuerungseinheit eine Selektions-Schnittstelle mit einem Sender zum Senden eines Selektionssignals zugeordnet ist, die Steuerungseinheit mittels ihrer Selektions-Schnittstelle drahtlos ein Selektionssignal zum Aktivieren eines Adressierungsmodus sendet und eines der Module als Zielmodul mittels der zugehörigen Selektions-Schnittstelle das Selektionssignal zum Aktivieren des Adressierungsmodus drahtlos empfängt. Der Aufbau eines galvanischen Kontaktes zwischen dem Anfangsmodul oder der Steuerungseinheit und dem Zielmodul ist nicht mehr notwendig, um ein Selektionssignal von dem Anfangsmodul beziehungsweise der Steuerungseinheit an das Zielmodul zu übertragen. Die Installation und/oder die Instandhaltung von einem oder von mehreren, nebeneinander angeordneten Modulen wird dank des erfindungsgemäßen Verfahrens auf besonders einfache und sichere Weise gewährleistet. Sollte beispielsweise eines von mehreren Modulen defekt sein, kann dieses durch ein baugleiches ersetzt werden. Um eine fehlerfreie Kommunikation zwischen den Modulen und/oder mit der Steuerungseinheit zu gewährleisten, bedarf es jedoch der Vergabe der Parallelbus-Adresse an das ersetzte Modul. Mittels des erfindungsgemäßen Verfahrens kann das ersetze Modul beziehungsweise des Zielmodul das Selektionssignal zum Aktivieren des Adressierungsmodus drahtlos empfangen. Der aktivierte Adressierungsmodus ermöglicht es sodann, dem Zielmodul eine Parallelbus-Adresse von der Steuerungseinheit zu vergeben. Nach der Vergabe der Parallelbus-Adresse an das Zielmodul kann das Zielmodul entsprechend dem zuvor ersetzten Modul adressiert werden. Eine mechanische und/oder konstruktive Beeinflussung benachbarter Module ist dazu nicht notwendig. Bevorzugt sind die Module entsprechend der erfindungsgemäßen Art ausgestaltet. Somit gewährleistet das erfindungsgemäße Verfahren eine besonders einfache und sichere Installation und/oder Wartung von mehreren, nebeneinander angeordneten Modulen.

Eine vorteilhafte Ausgestaltung des Verfahrens zeichnet sich dadurch aus, dass das Selektionssignal bei benachbarten Modulen drahtlos von Modul zu Modul an das Zielmodul übertragen wird. Bei benachbarten Modulen, die das Selektionssignal drahtlos von Modul zu Modul übertragen, handelt es sich vorzugsweise um die Module zwischen der Steuerungseinheit beziehungsweise dem Anfangsmodul und dem Zielmodul. Eine erneute Adressierung ist bei diesen Modulen nicht notwendig, da diese zumeinst schon eine Parahelbusadresse aufweisen und/oder diesen Modulen bereits eine Parallelbusadresse zugeordnet wurde. Die Selektions-Schnittstehen der entsprechenden oder sendenden Module weisen dazu bevorzugt jeweils einen Sender zum Senden des Selektionssignals auf. Werden beispielsweise drei Module nebeneinander angeordnet, so kann das Selektionssignal von der Steuerungseinheit drahtlos zum ersten Modul, von dem ersten Modul drahtlos zu dem zweiten Modul und von dem zweiten Modul drahtlos zu dem dritten Modul, also dem Zielmodul, übertragen werden. In diesem Fall können die Selektions-Schnittstellen des ersten Moduls und des zweiten Moduls jeweils einen Sender zum, insbesondere drahtlosen, Senden des Selektionssignals aufweisen.

Eine vorteilhafte Ausgestaltung des Verfahrens zeichnet sich dadurch aus, dass das Zielmodul durch den Empfang des Selektionssignals zum Aktivieren des Adressierungsmodus einen zugehörigen Adressierungsmodus zum Empfang einer Parallelbus-Adresse mittels der zugehörigen Parallelbus-Schnittstelle aktiviert. Mit dem Zielmodul ist bevorzugt das Modul gemeint, in dem das Selektionssignal endet oder das das Selektionssignal nicht weitersendet. Mit anderen Worten ist damit bevorzugt das Modul gemeint, dem noch keine Parallelbus-Adresse zugeordnet wurde oder das keine Parallelbus-Adresse aufweist und (gilt für beide Alternativen) das Selektionssignal zum Aktivieren des Adressierungsmodus empfängt, Unter Bezugnahme auf das vorangegangene erläuterte Beispiel würde das dritte Modul den zugehörigen Adressierungsmodus aktivieren, wenn das erste Modul und das zweite Modul bereits eine Parallelbus-Adresse aufweisen bzw. diesen Modulen bereits jeweils eine Parallelbus-Adresse zugewiesen wurde. Dank dieser Ausgestaltung kann einer Mehrzahl von Modulen jeweils nacheinander überraschend einfach und sicher eine Parallelbus-Adresse automatisch zugewiesen werden.

Eine weitere vorteilhafte Ausgestaltung des Verfahrens zeichnet sich dadurch aus, dass die Steuerungseinheit mittels ihrer Parallelbus-Schnittstelle und des damit verbundenen Parallelbusses eine Parallelbus-Adresse sendet. Unter erneuter Bezugnahme auf das Beispiel könnte die Steuerungseinheit die Parallelbus-Adresse "des dritten Moduls" senden. Eine vorteilhafte Weiterbildung des Verfahrens sieht vor, dass das Zielmodul im Adressierungsmodus die von der Steuerungseinheit versandte Parallelbus-Adresse mittels der zugehörigen Parallelbus-Schnittstelle empfängt. Eine zweckmäßige Weiterbildung des Verfahrens sieht vor, dass das Zielmodul die empfangene Parallelbus-Adresse als die eigene Parallelbus Adresse speichert, den Adressierungsmodus deaktiviert und das Selektionssignals mittels der zugehörigen Selektionsschnittstelle an ein benachbartes Modul als neues Zielmodul überträgt. Damit ist es auf besonders einfache und sichere Weise möglich, Parallelbus-Adressen an nebeneinander angeordnete Module zu vergeben. Eine entsprechende Vergabe von Parallelbus-Adressen ist sowohl bei der Installation eines Moduls oder eines Systems mit mindestens einem derartigen Modul von Vorteil als auch bei der Wartung des Moduls oder eines Systems mit mindestens einem derartigen Modul.

Weitere vorteilhafte oder zweckmäßige Merkmale und Ausgestaltungen der Erfindung ergeben sich aus den Unteransprüchen sowie aus der Beschreibung. Eine besonders bevorzugte Ausführungsform wird anhand der beigefügten Zeichnungen näher erläutert. In den Zeichnungen zeigen:
- Fig. 1: eine schematische Seitenansicht erfindungsgemäßer Module und eines erfindungsgemäßen Systems mit derartigen Modulen,
- Fig. 1a: eine weitere schematische Seitenansicht erfindungsgemäßer Module und eines erfindungsgemäßen Systems mit derartigen Modulen,
- Fig. 2: beispielhafte Signalzustände der von den Sendern der Module und/oder Steuerungseinheit versandte Signale sowie
- Fig. 3: eine schematische Seitenansicht einer besonders vorteilhaften Ausgestaltung von zwei erfindungsgemäßen Modulen.

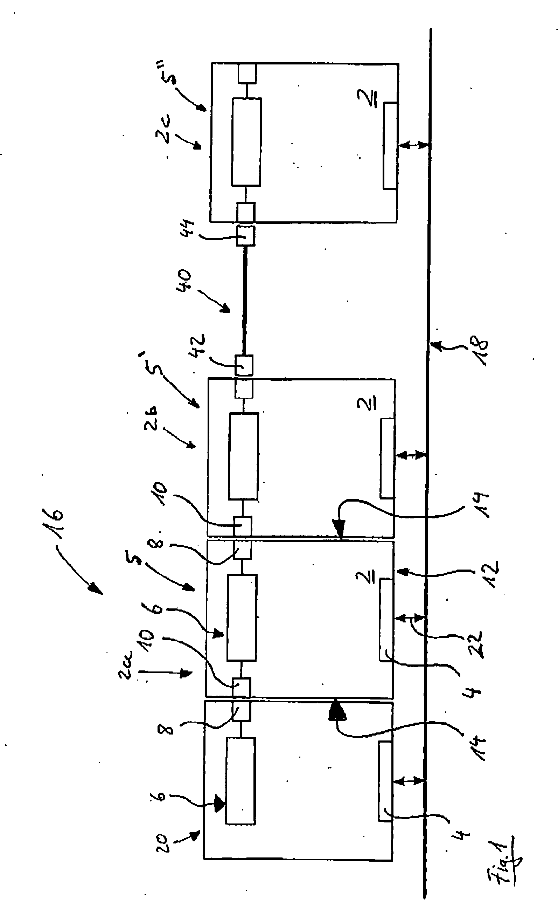

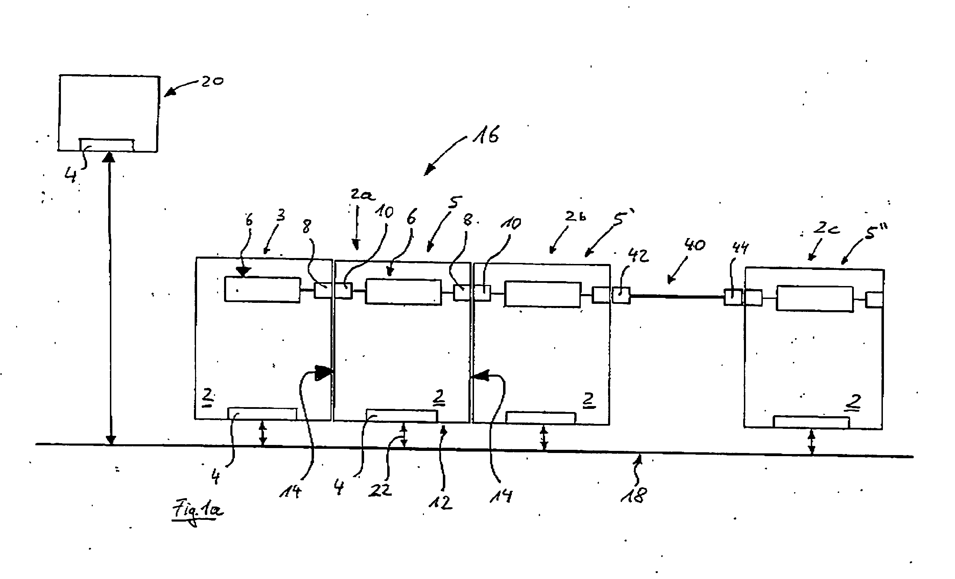

In der Fig. 1 ist ein Modul 2 mit einem Schnellbefestigungsmittel (nicht dargestellt) zur Befestigung des Moduls 2 auf einer Modulaufnahme (nicht dargestellt), einer Parallelbus-Schnittstelle 4 zum Senden und/oder Empfangen von Daten, Adressen und/oder Steuersignalen und mit einer Selektions-Schnittstelle 6 dargestellt, wobei die Selektions-Schnittstelle 6 einen Sender 8 zum Senden eines Selektionssignals und/oder einen Empfänger 10 zum Empfang eines Selektionssignals aufweist, wobei das Schnellbefestigungsmittel an der Bodenwand 12 des Moduls 2 angeordnet ist, und wobei die Seitenwände 14 vorsprungsfrei ausgestaltet sind.

Die Modulaufnahme und das Schnellbefestigungsmittel sind aus dem Stand der Technik bekannt. Bei der Madulaufnahme handelt es sich beispielsweise um eine Trägerschiene oder um eine sogenannte Hutschiene. Daran angepasste Schnellbefestigungsmittel zur Befestigung des Moduls 2 auf einer derartigen Modulaufnahme sind beispielsweise aus dem Patentdokument DE 10 2007 022 806 B3 bekannt. Derartige Schnellbefestigungsmittel weisen für gewöhnlich zwei Widerhakenmittel auf, wobei mindestens das eine der beiden Widerhakenmittel gegen eine Federkraft schwenkbar ausgestaltet ist. Damit kann ein derartiges Schnellbefestigungsmittel auf der entsprechenden Modulaufnahme besonders einfach und schnell befestigt und/oder gelöst werden.

Die aus dem Stand der Technik bekannten, herkömmlichen Verbindungsstrukturen zwischen einer Steuerungseinheit 20 und/oder mehreren Modulen 2 sind parallele Busse, an die diese als "Buskomponenten" (Master und/oder Slave) über mechanisch, elektrisch und/oder funktionell spezifizierte Schnittstellen ankoppelbar sind. Mittels des Parallelbusses 18 können also mehrere "Buskomponenten" parallel verbunden werden. Um das erfindungsgemäße Modul 2 mit einem Parallelbus 18 zu verbinden, weist dieses eine Parallelbus-Schnittstelle 4 auf. Die Parallelbus-Schnittstelle 4 dient zum Senden und/ oder empfangen von Daten, Adressen und/oder Steuersignalen.

Die Kommunikation mittels des Parallelbusses 18 erfolgt zumeist in einem sogenannten Buszyklus. Dazu wird von einem sogenannten Master zunächst eine Lese- oder Schreiboperation ausgelöst. Dazu sind aus dem Stand der Technik sogenannte Busprotokolle bekannt, die diese entsprechenden Operationen regeln. Eine entsprechende Schreib- oder Leseoperation umfasst dabei zweckmäßigerweise auch die Adressierung des sogenannten Slaves und eine Übertragungssynchronisation. In einer zweckmäßigen Ausgestaltung können der Master und der Slave mittels eines gemeinsamen Bustaktes miteinander synchronisiert sein. Die Adressierung des Slaves, also die entsprechende Auswahl des Slaves, mit dem der Master kommunizieren möchte, erfolgt in der Praxis zumeist durch die Auswertung der vom Master versandten Adresse. Stellt mindestens ein Slave durch die Adressauswertung fest, dass die entsprechende Adresse mit der eigenen Adresse übereinstimmt, kann dieser mindestens eine Slave die vom Master daraufhin verschickten Daten und/oder Steuersignale empfangen und entsprechend weiterverarbeiten. Zur Auswertung der Adressen ist zumeist auch eine Dekodierung notwendig. Denn die Daten, Adressen und/oder Steuersignale werden oftmals in kodierter Form mittels des Parallelbusses 18 kommuniziert. Sofern alle an einen Parallelbus 18 angeschlossenen "Buskomponenten" jeweils eine Parallelbus-Adresse aufweisen, ist mit den aus dem Stand der Technik bekannten Verfahren und/oder Vorrichtungen eine zielsichere Kommunikation zwischen mindestens zwei der "Buskomponenten" möglich, Bevorzugt spiegeln die Steuerungseinheit und/oder die Module die "Buskomponenten" wider, so dass eine entsprechende Kommunikation ermöglicht wird.

Module 2 der erfindungsgemäßen Art werden vielfach in der Prozess-, Automatisierungs- und Steuerungstechnik eingesetzt. So kann beispielsweise eine Brandfallzentrale eine Mehrzahl der erfindungsgemäßen Module 2 aufweisen. Bei der Installation einer derartigen Brandfallzentrale weisen die erfindungsgemäßen Module 2 jedoch oftmals keine, eine unbekannte oder nicht eine richtige Adresse auf, mit der sie adressiert werden könnten, um eine Kommunikation mittels des Parallelbusses 18 aufzubauen. Mit anderen Worten ist es bei der Installation und/oder bei der Wartung notwendig, dass eine Steuerungseinheit 20 eine Parallelbus-Adresse an das erfindungsgemäße Modul 2 vergibt. Daraufhin ist die Parallelbus-Adresse des erfindungsgemäßen Moduls 2 bekannt, so dass dieses Modul 2 adressiert werden kann. Mehrere erfindungsgemäße Module 2 können voneinander abweichende Parallelbus-Adressen aufweisen, Grundsätzlich ist es aber auch möglich, dass mehrere der erfindungsgemäßen Module 2 die gleiche Parallelbus-Adresse aufweisen. Dies ist insbesondere dann zweckmäßig, wenn es sich um baugleiche Module 2 handelt.

Aus dem Stand der Technik ist eine Vielzahl von Parallelbussystemen bekannt, wobei der Control Area Nehvork-Bus (CAN-Bus) eine besondere Ausgestaltungsvariante darstellt. Für eine zielsichere Kommunikation ist es auch hierbei notwendig, dass die Module 2 jeweils eine (insbesondere eindeutige) Parallelbus-Adresse aufweisen. Module 2 mit einer CAN-Bus-Schnittstelle weisen häufig einen sogenannten Kodierschalter auf, der dazu eingerichtet und/oder ausgebildet ist, die Parallelbus-Adresse des jeweiligen Moduls 2 manuell einzustellen. Hierbei besteht jedoch die Gefahr, dass die Parallelbus-Adresse falsch eingestellt, eine bereits korrekt eingestellte Parallelbus-Adresse falschlicherweise geändert oder eine bereits vergebene Parallelbus-Adresse fälschlicherweise doppelt vergeben wird. Wird an ein Modul 2 eine falsche Parallelbus-Adresse vergeben, so kommt es zu Kommunikationsfehlern und ein sicherer Anlagenbetrieb ist nicht mehr möglich.

Die aus dem Stand der Technik bekannten Module der Modulserie "ME ® der Firma "Phoenix Contact" weisen an einer Seitenwand einen hervorspringenden Stecker und an einer weiteren Seitenwand eine korrespondierende Buchse auf. Mehrere dieser bekannten Module können auf einer Hutschiene in der Art und Weise nebeneinander angeordnet sein, dass jeweils ein hervorspringender Stecker des einen Moduls in die korrespondiert ausgestaltete Buchse des benachbarten Moduls fasst, Mittels des Stecksystems, bestehend aus dem hervorspringenden Stecker und der entsprechend ausgestalteten Buchse, kann zwischen zwei benachbarten Modulen eine galvanische Verbindung hergestellt werden. Mittels dieser Modul-zu-Modul-Verbindung ist eine automatische Vergabe von Parallelbus-Adressen von einer Steuerungseinheit an Module möglich. Der bekannte hervorspringende Stecker eines Moduls der Modulserie"ME" ® der Firma "Phoenix Contact" kann somit zumindest einen Teil eines Senders zum Senden eines Selektionssignals darstellen, Entsprechendes gilt für den Empfänger. Die zu dem Stecker korrespondierend ausgestaltete Buchse des Moduls der Modulserie "ME" ® kann zumindest einen Teil des Empfängers zum Empfangen eines Selektionssignals darstellen. Somit ist aus dem Stand der Technik eine Selektions-Schnittstelle 6 mit einem Sender 8 zum Senden eines Selektionssignals und/oder einem Empfänger 10 zum Empfang eines Selektionssignals bekannt. Der Sender 8 bzw. der Empfänger 10 können des Weiteren die aus dem Stand der Technik bekannten und/oder gegebenenfalls notwendigen elektrischen Schaltungen umfassen.

Mit dem Selektionssignal ist bevorzugt ein Signal gemeint, das geeignet ist, einen Adressierungsmodus des Moduls 2 zu aktivieren. Der Adressierungsmodus des Moduls 2 -zeichnet sich bevorzugt dadurch aus, dass eine von dem Modul 2 mittels der zugehörigen Parallelbus-Schnittstelle 4 empfangene Adresse von dem Modul 2 als die eigene Adresse gespeichert wird oder speicherbar ist. Mit anderen Worten zeichnet sich der Adressierungsmodus des Moduls 2 bevorzugt dadurch aus, dass Daten (im allgemeinen Sinne) mittels der Parallelbus-Schnittstelle 4 eines nicht adressierten Moduls 2 empfangbar sind und diese empfangen Daten als die Parallelbus-Adresse des entsprechenden Moduls 2 abspeicherbar sind, Mittels des Adressierungsmodus wird somit eine Ausnahme von der Regel geschaffen, dass ein Modul 2 nur dann Daten und/oder Steuersignale empfängt, wenn dieses (richtig) adressiert ist. Die dazu notwendige Auswertung der Adresse wurde bereits zuvor erläutert. Mittels des Adressierungsmodus ist es somit besonders einfach und vorteilhaft möglich, einem Modul 2 mit einer unbekannten, einer falschen oder ohne Parallelbus-Adresse eine gewünschte (neue) Parallelbus. Adresse zu geben oder zuzuweisen.

Zur Befestigung des Moduls 2 auf einer Modulaufnahme weist das Modul 2 erfindungsgemäß ein Schnellbefestigungsmittel auf. Dieses Schnellbefestigungsmittel ist bevorzugt an der Bodenwand 12 des Moduls 2 angeordnet. Die Bodenwand 12 ist bevorzugt die untere Begrenzung des Moduls. Da die Modulaufnahme nicht nur in einer horizontalen Ebene, sondern auch in einer vertikalen oder einer anderen beliebigen Ebene angeordnet sein kann, gilt Entsprechendes somit auch für das Modul 2. Unter der Bodenwand 12 des Moduls 2 ist somit bevorzugt die Wand des Moduls 2 zu verstehen, die zweckmäßigerweise der Modulaufnahme zugewandt ist oder zum Zuwenden der Modulaufnahme, insbesondere durch das Schnellbefestigungsmittel, eingerichtet und/oder ausgebildet ist. Somit ist es grundsätzlich möglich, dass die Bodenwand 12 eines auf einer Modulaufnahme befestigten Moduls 2 in einer vertikalen Ebene angeordnet ist.

Erfindungsgemäß sind die Seitenwände 14 des Moduls 2 vorsprungsfrei ausgestaltet. Mit den Seitenwänden 14 des Moduls 2 sind insbesondere die auf der Bodenwand 12 stehenden, insbesondere gegenüber angeordneten, Wände gemeint, die dazu eingerichtet und/oder ausgebildet sind, um jeweils ein weiteres Modul 2 möglichst spaltfrei daran angrenzend anzuordnen. Sind mehrere Module 2 nebeneinander angeordnet, so sind beispielsweise die Seitenwände 14 eines mittig angeordneten Moduls 2 die auf der Bodenwand stehenden und gegenüberliegend angeordneten Wände, die jeweils zu den nebengeordneten Modulen 2 grenzen. Mit anderen Worten grenzen die Seitenwände 14 des mittig angeordneten Moduls 2 jeweils an eine Seitenwand 14 eines benachbarten Moduls 2. Ist ein Modul 2 beispielsweise dazu eingerichtet und ausgebildet, um nur an einer auf der Bodenwand stehenden Seitenwand 14 ein weiteres Modul 2 möglichst spaltfrei angrenzend anzuordnen, so kann in einer bevorzugten Ausgestaltung unter der beispielhaft genannten Seitenwand 14 eine Seitenwand 14 im Sinne der Erfindung verstanden werden. Entsprechendes gilt, wenn das Modul 2 dazu eingerichtet und ausgebildet ist, um an mehreren, insbesondere drei oder vier, auf der Bodenwand 12 stehenden Seitenwänden 14 jeweils ein weiteres Modul 2 möglichst spaltfrei daran angrenzend anzuordnen.

Dank der erfindungsgemäßen Ausgestaltung des Moduls 2 ist eine einfache und sichere Installation und/oder Instandhaltung von mehreren, nebeneinander angeordneten Modulen 2 möglich. Denn die Seitenwände 14 des Moduls 2 sind vorsprungsfrei ausgestaltet. Damit können mehrere Module 2 zumindest im Wesentlichen spaltfrei nebeneinander auf einer Modulaufnahme befestigt werden. Obwohl die Module 2 derart dicht nebeneinander angeordnet werden können, besteht nicht die Gefahr, dass sich die Module untereinander verhaken und/oder ein Herausnehmen eines der Module 2 gegenseitig blockieren. Vielmehr kann jedes der Module 2 aus einer Anordnung von mehreren direkt nebeneinander angeordneten Modulen 2 herausgezogen werden, ohne die restlichen Module 2 seitlich verschieben zu müssen. Beim Auswechseln eines Moduls 2 können somit die restlichen Module 2 unverändert bleiben. Entsprechendes gilt, wenn eine Anordnung von mehreren nebeneinander angeordneten Modulen 2 um ein weiteres Modul 2 erweitert werden soll. Dank ihrer jeweiligen Parallelbus-Schnittstelle 4 und ihrer jeweiligen Selektions-Schnittstelle 6 kann jedem der Module 2 überraschend einfach eine Parallelbus-Adresse zugeordnet werden. Dies kann unabhängig davon erfolgen, ob das jeweilige Modul 2 bereits eine Parallelbus-Adresse aufweist. Somit können mehrere Module 2 in einer gewünschten Reihenfolge nebeneinander auf einer Modulaufnahme angeordnet werden, um diesen daraufhin mittels der jeweiligen Selektions-Schnittstelle 6 und der jeweiligen Parallelbus-Schnittstelle 4 eine Parallelbus-Adresse zu geben. Entsprechendes gilt auch für die Instandhaltung derartiger Module 2. Wird beispielsweise ein Modul 2 durch ein neues oder anderes Modul 2 ersetzt, so kann diesem Modul 2 mittels der zugehörigen Parallelbus-Schnittstelle 4 und der zugehörigen Selektions-Schnittstelle 6 die entsprechend gewünschte Parallelbus-Adresse zugewiesen werden.

Bevorzugt ist die Selektions-schnittstelle 6 eine drahtlose Schnittstelle bzw. eine Drahtlos-Schnittstelle. Das bedeutet nicht, dass die Selektions-Schnittstelle 6 als solche keinen Draht aufweisen darf. Vielmehr ist damit bevorzugt gemeint, dass die Selektions-Schnittstelle 6 zur drahtlosen Kommunikation eingerichtet und/oder ausgebildet ist. Somit kann der Sender 8 der Selektions-Schnittstelle zum drahtlosen Senden eines Selektionssignals eingerichtet und ausgebildet sein. Entsprechendes gilt für den Empfangger 10 der Selektions-Schnittstelle 6. Der Empfänger 10 kann zum drahtlosen Empfang eines Selektionssignals eingerichtet und/oder ausgebildet sein. Dank dieser Ausgestaltung können zwei Module 2 direkt nebeneinander angeordnet sein, ohne die Selektions-Schnittstellen 6 mechanisch und/oder galvanisch miteinander verkoppeln zu müssen. Zur Übertragung eines Selektionssignals zwischen zwei Selektions-Schnittstellen 6 ist somit kein elektrischer Leiter notwendig. Vielmehr kann der insbesondere freie Raum zwischen zwei Selektions-Schnittstellen 6 genutzt werden, um ein Selektionssignal von einem Sender 8 eines ersten Moduls 2 zu dem Empfänger 10 eines zweiten Moduls 2 zu übertragen.

Bevorzugt weist der Sender 8 der Selektions-Schnittstelle 6 eine Lichtquelle auf. Diese Lichtquelle ist beispielsweise eine LED. Grundsätzlich sind als Lichtquelle aber auch andere aus dem Stand der Technik bekannte Lichtquellen, wie beispielsweise eine Glühlampe oder ein Laserpointer, geeignet. Das von dem Sender 8 ausgesendete Licht kann drahtlos zu einem Empfänger 10 einer weiteren Selektions-Schnittstelle 6 eines weiteren Moduls 2 gesendet werden, Eine vorteilhafte Ausgestaltung der Erfindung zeichnet sich deshalb dadurch aus, dass der Empfänger 10 der Selektions-Schnittstelle 6 einen optischen Sensor aufweist. Dieser Sensor kann beispielsweise ein Lichtstärkensensor sein. Ist eine Lichtquelle eines Senders 8 zum Senden von Licht mit zwei unterschiedlichen Lichtstärken eingerichtet, so kann die jeweils gesendete Lichtstärke von einem optischen Sensor empfangen und entsprechend ausgewertet werden.

Für eine weitere vorteilhafte Ausgestaltung der Erfindung kann der Sender 8 der Selektions-Schnittstelle 6 eine induktive Quelle, eine akustische Quelle oder einen mechanisehen Stempel aufweisen. Analog hierzu kann der Empfänger 10 der Selektions-Schnittstelle 6 einen Induktionssensor, einen akustischen Sensor oder einen mechanischen Sensor aufweisen.

Aus der Fig. 1 geht des Weiteren ein System 16 mit einer Modulaufnahme (nicht dargestellt), einem Parallelbus 18, einer Steuerungseinheit 20, der eine Parallelbus-Schnittstelle 4 zum Senden und/oder Empfangen von Daten, Adressen und/oder Steuersignalen zugeordnet ist, dargestellt, wobei die Parallelbus-Schnittstelle 4 der Steuerungseinheit 20 mit dem Parallelbus 18 verbunden ist, und wobei das System 16 mindestens ein erfindungsgemäßes Modul 2 in Signalverbindung 22 mit der Steuerungseinheit 20 aufweist. Bevorzugt ist es vorgesehen, dass der Selektions-Schnittstelle 6 der Steuerungseinheit 20 ein Sender 8 zum Senden eines Selektionssignals zugeordnet ist.

Die Modulaufnahme und der Parallelbus 18 wurden bereits zuvor umfänglich erläutert. In einer bevorzugten Ausgestaltung ist der Parallelbus 18 von der Modulaufnahme integriert. Eine entsprechende Ausgestaltung, beispielsweise der "In-Rail-Bus" ® der Firma "Dold", ist aus dem Stand der Technik bekannt.

Die in dem zurückliegenden sowie im weiteren Text beschriebenen Details und/oder vorteilhafte Ausgestaltungen der Parallelbus-Schnitistelle 4 und/oder der Selektions-Schnittstelle 6 gelten gleichermaßen für das erfindungsgemäße Modul 2 bzw. für die Steuerungseinheit 20 des Systems 16. Denn das erfindungsgemäße Modul 2 kann grundsätzlich als Peripheriemodul oder als Steuerungseinheit 20 ausgestaltet und/oder ausgebildet sein, Als Peripheriemodul kann das erfindungsgemäße Modul 2 Verbindungen zu peripheren Sensoren, z.B. Brandmelder, Alarmmitteln, z.B. Blitzleuchten und/oder Hupen, Aktuatoren, z.B. Ventile zum Auslösen von Löschanlagen, Auslöseeinheiten und/oder ähnlichen Einheiten aufweisen. Als Steuerungseinheit 20 kann das erfindungsgemäße Modul 2 als eine (insbesondere übergeordnete) Einheit für eine Prozess-, Automatisierungs- und Steuerungstechnik wirken. Das als Steuerungseinheit 20 ausgestaltete Modul 2 kann zur Vergabe von Parallelbus-Adressen an Peripheriemodule eingerichtet und/oder ausgestaltet sein. Somit kann die Steuerungseinheit 20 auch von einem Modul 2 umfasst sein,

Die Steuerungseinheit 20 kann in einer weiteren vorteilhaften Ausgestaltung separat ausgestaltet sein. Es ist also nicht notwendig, dass die Steuerungseinheit 20 direkt neben dem erfindungsgemäßen Modul 2 angeordnet ist. Ein Schaltschrank kann beispielsweise in der Weise aufgebaut sein, dass mehrere nebeneinander angeordnete Module 2 örtlich getrennt von der Steuerungseinheit 20 angeordnet sind. Eine alternative, vorteilhafte Ausgestaltung des Systems 16, wie sie auch in Fig. 1 dargestellt ist, zeichnet sich dadurch aus, dass eines der Module 2 seitlich an der Steuerungseinheit 20 grenzend angeordnet ist. In dieser Ausgestaltungsvariante ist das System 16 besonders kompakt.

Zum Senden und/oder Empfangen von Daten, Adressen und/oder Steuersignalen ist die Parallelbus-Schnittstelle 4 der Steuerungseinheit 20 des Systems 16 mit dem Parallelbus 18 verbunden. Bei der entsprechenden Verbindung handelt es sich zumindest um eine Signalverbindung 22, die das entsprechende Senden und/oder Empfangen gewährleistet. Darüber hinaus kann es sich auch um eine mechanische Verbindung im Sinne eines mechanischen Kontakts und/oder Zusammenhalts oder um eine elektrische Verbindung im Sinne einer elektrisch leitenden Kontaktierung handeln.

Des Weiteren weist das erfindungsgemäße System 16 mindestens ein erfindungsgemäßes Modul 2 in Signalverbindung 22 mit der Steuerungseinheit 20 auf. Wie in Fig. 1 dargestellt, kann die Signalverbindung 22 mittels des Parallelbusses 18 sowie der jeweiligen Parallelbus-Schnittstellen 4 der Steuerungseinheit 20 und des mindestens einen Moduls 2 gewährleistet sein. Mittels der Signalverbindung 22 kann die Steuerungseinheit 20 Daten, Adressen und/oder Steuersignale an mindestens eines der Module 2 senden. Die Kommunikation kann auch in umgekehrter Richtung erfolgen. So kann beispielsweise ein Modul 2 Daten, Adressen und/oder Steuersignale zu der Steuerungseinheit 20 und/oder zu einem weiteren Modul 2 senden.

In einer bevorzugten Ausgestaltung ist das System 16 eine Brandfallzentrale, insbesondere Ansteuerungseinrichtung, zur Steuerung von Löscheinrichtungen, welche beispielsweise mit flüssigen, gasförmigen, pulverförmigen und/oder schaumförmigen Löschmitteln betrieben werden können. Derartige Löscheinrichtungen verfügen für gewöhnlich über ein Löschmittelreservoir, welches über ein, insbesondere verzweigtes, Rohrleitungssystem mit steuerbaren Ventilen und/oder mit Löschdüsen verbunden ist. Entsprechende Aktuatoren, insbesondere Ventile, Pumpen etc. können mit mindestens einem der erfindungsgemäßen Module 2 verbunden sein, um die Aktuatoren entsprechend der Löschaufgabe zu steuern. Je nach Art und Umfang der Brandgefährdung können die Menge und/oder die Art der Ausbringung des Lösehmittels mittels der Brandfallzentrale steuerbar sein. Zur frühzeitigen Erkennung eines Brands kann die Brandfallzentrale, insbesondere die Brandmelderzentrale, mindestens einen Detektor zur Erfassung von einer oder verschiedenen Brandkenngrößen aufweisen. Für eine wirksame Brandbekämpfung ist jedoch der Zeitpunkt und die sichere Erkennung des Brands besonders wichtig. Die Detektoren können jeweils über Signalleitungen mit mindestens einem der erfindungsgemäßen Module 2 verbunden sein. Übliche messbare Brandkenngrößen sind beispielsweise die Temperatur, die Strahlung, eine Konzentration von Aerosolen und/oder brandcharakteristische Gase. Mittels der Brandfallzentrale bzw, der Brandmelderzentrale können die messbaren Brandkenngrößen ausgewertet werden. Dazu kann die Brandfallzentrale bzw. Brandmelderzentrale eine entsprechende Auswerteeinheit aufweisen. Entsprechende Verfahren und/oder Auswerteeinheiten sind aus dem Stand der Technik bekannt. Dabei kann die Auswertung zumindest teilweise durch die erfindungsgemäßen Module 2 und/oder durch die Steuerungseinheit 20 erfolgen. Im Alarmfall können entsprechende Steuersignale an die Löscheinrichtung übermittelt werden, um den erkannten Brand mittels der Löschmittel zu löschen. Dies kann ebenfalls durch die erfindungsgemäßen Module 2 und/oder durch die Steuerungseinheit 20 erfolgen.

Insbesondere im Bereich der Branderkennungs- und Bekämpfungstechnik ist es besonders wichtig und von hohem Interesse, Brandfallzentralen über Jahre störungsfrei zu betreiben. Aber auch in anderen Bereichen der Technik ist es grundsätzlich wichtig, ein System 16 störungsfrei über mehrere Jahre hinweg betreiben zu können. Sollte dennoch ein Störungsfall auftreten, so besteht grundsätzlich ein hohes Interesse daran, den Störungsfall möglichst schnell zu beseitigen. In der Praxis werden dazu oftmals die gestörten und/oder defekten Bauteile bzw. Einheiten ausgetauscht, um möglichst schnell den störungsfreien Betrieb wieder zu ermöglichen. Aber selbst wenn die Bauteile und/oder Einheiten scheinbar störungsfrei funktionieren, besteht die Gefahr, dass die Funktion der Bauteile und/oder Einheiten fehlerhaft ist. Dies kann beispielsweise darauf zurückzuführen sein, dass einem Modul 2 mittels eines Kodierschalters händisch eine falsche Parallelbus-Adresse zugewiesen wurde. In diesem Fall kann das entsprechende Modul 2 nicht wie gewünscht betrieben werden. Es besteht deshalb der Wunsch, die Adressierung eines Moduls 2 möglichst sicher und einfach zu gestalten.

Eine vorteilhafte Lösung bietet das erfindungsgemäße Verfahren zur Vergabe von Parallelbus-Adressen von einer Steuerungseinheit 20 an Module 2, wobei der Steuerungseinheit 20 eine Parallelbus-Schnittstelle 4 zum Senden und/oder Empfangen von Daten, Adressen und/oder Steuersignalen zugeordnet ist, und wobei jedes Modul 2 eine Parallelbus-Schnittstelle 4 zum Senden und/oder Empfangen von Daten, Adressen und/oder Steuersignalen und eine Selektions-Schnittstelle 6 mit einem Sender 8 zum Senden eines Selektionssignals und/oder einem Empfänger 10 zum Empfang eines Selektionssignals aufweist.

Eine in Fig. 1a dargestellte erfindungsgemäße Variante des Verfahrens zeichnet sich dadurch aus, dass eines der Module 2 als Anfangsmodul 3 mittels der zugehörigen Selektions-Schnittstelle 6 drahtlos ein Selektionssignal zum Aktivieren eines Adressierungsmodus sendet und ein weiteres der Module 2 als Zielmodul 5 mittels der zugehörigen Selektions-Schnittstelle 6 das Selektionssignal zum Aktivieren des Adressierungsmodus drahtlos empfängt.

Eine in Fig.1 dargestellte, alternative oder weitere erfindungsgemäße Variante des Verfahrens zeichnet sich dadurch aus, dass der Steuerungseinheit 20 eine Selektions-Schnittstelle 6 mit einem Sender 8 zum Senden eines Selektionssignals zugeordnet ist, die Steuerungseinheit 20 mittels ihrer Selektions-Schnittstelle 6 drahtlos ein Selektionssignal zum Aktivieren eines Adressierungsmodus sendet und eines der Module 2 als Zielmodul 5 mittels der zugehörigen Selektions-Schnittstelle 6 das Selektionssignal zum Aktivieren des Adressierungsmodus drahtlos empfängt.

Damit wird ein vorteilhaftes Verfahren zur Vergabe von Parallelbus-Adressen geschaffen, das eine einfache und sichere Installation und/oder Instandhaltung von mindestens einem oder von mehreren, nebeneinander angeordneten Modulen 2 ermöglicht. Dank des erfindungsgemäßen Verfahren ist es nicht mehr notwendig, dass einem Modul 2 händisch, insbesondere mittels eines Kodierschalters, eine Parallelbus-Adresse zugewiesen wird. Die Gefahr, dass mehrere Module 2 fälschlicherweise die gleiche Adresse erhalten, dass ein Modul 2 eine falsche Adresse erhält, und/oder dass ein Modul 2 gar keine Adresse erhält, sinkt dank des erfindungsgemäßen Verfahrens deutlich, Denn mittels des erEndungsgemäßen Verfahrens kann eine automatische Vergabe von Parallelbus-Adressen von einer Steuerungseinheit 20 an mindestens ein Modul 2, nämlich das Zielmodul 5, erfolgen. Ferner ermöglicht das erfindungsgemäße Verfahren eine besonders einfache Installation und/oder Instandhaltung von mindestens einem Modul 2. Dies gilt insbesondere, wenn mehrere Module 2 nebeneinander angeordnet sind. Denn dank der drahtlosen Übermittlung des Selektionssignals ist zwischen der Selektions-Schnittstelle 6 der Steuerungseinheit 20 beziehungsweise der Selektions-Schnittstelle des Anfangsmoduls 3 und der Selektionsschnittstelle 6 des Zielmoduls 5 keine drahtgebundene und/oder galvanische und/oder mechanische Verbindung mehr nötig. Die drahtlose, insbesondere kontaktlose, Kommunikation des Selektionssignals ermöglicht deshalb eine ungehinderte Installation und/oder Instandhaltung von einem Modul 2, insbesondere wenn dieses zwischen zwei weiteren Modulen 2 im Wesentlichen spaltfrei angeordnet werden soll.

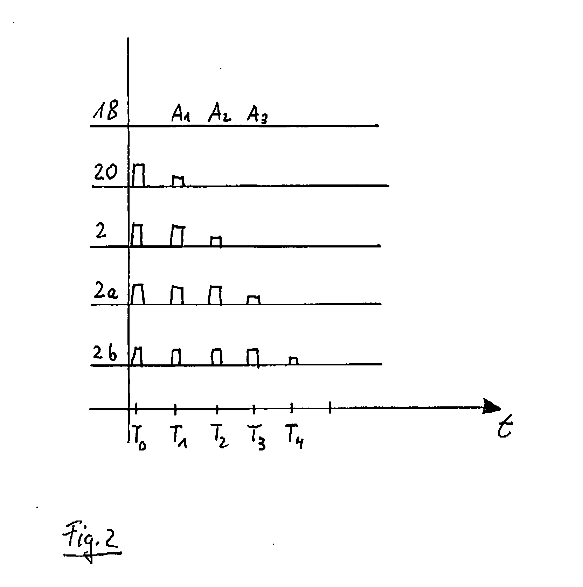

Beispielhaft werden im Folgenden mehrere Schritte zur Vergabe von einer Parallelbus-Adresse unter Bezugnahme auf Fig. 1 in Verbindung mit Fig. 2 erläutert. Neben der bereits genannten Steuerungseinheit 20 sind auch die Module 2a, 2b und 2c dargestellt. Die unterschiedlichen Buchstaben der Module dienen nur zur besseren Erläuterung, denn alle Module sind bevorzugt nach Art des erfindungsgemäßen Moduls 2 eingerichtet und/oder ausgebildet. Die Steuerungseinheit 20 und die Module 2a, 2b und 2c sind in 1 einer Reihe nebeneinander angeordnet. Das Modul 2c ist hierbei von dem Modul 2b beabstandet. Die Steuerungseinheit 20 und die Module 2a und 2b sind im Wesentlichen spaltfrei nebeneinander angeordnet. Die Module 2a, 2b und 2c sind mittels ihrer jeweiligen Parallelbus-Schnittstelle 4, dem Parallelbus 18, und der Parallelbus-Schnittstelle 4 der Steuerungseinheit 20 in Signalverbindung mit der Steuerungseinheit 20. Der Sender 8 und der Empfänger 10 der Selektions-Schnittstelle 6 der jeweiligen Module 2a, 2b und 2c sind an jeweils zwei gegenüberliegenden Seitenwänden des entsprechenden Moduls 2a, 2b, 2c angeordnet. Bei direkt benachbarten Modulen, beispielsweise Module 2a und 2b, sind somit auch die direkt benachbarten Seitenwände gegentiberliegend angeordnet. Entsprechendes gilt auch für die Module 2b und 2c oder für die Steuerungseinheit 20 und das Modul 2a. Somit kann jeweils der Sender 8 der Steuerungseinheit 20 oder des Moduls 2a, 2b gegenüber von dem Empfängers 10 des Moduls 2a bzw. der weiteren Module 2b, 2c angeordnet sein. Damit wird erreicht, dass ein Sender 8 einer ersten Selektions-Schnittstelle 6 zum Senden des Seletionssignals zu einem gegenüberliegenden Empfänger 10 einer zweiten Selektions-Schnittstelle 6 ausgerichtet ist. Der Empfänger 1 10 der zweiten Selektions-Schniftstelle 6 kann zum Empfang des Selektionssignals eines gegentiberliegenden Senders 8 einer ersten Selektions-Schnittstelle 6 ausgerichtet sein. Mit anderen Worten: Der Sender einer Steuerungseinheit 20 oder eines Moduls 2a, 2b kann das Selektionssignal bevorzugt nur an einen gegenüberliegenden Empfänger 10 eines, insbesondere direkt, benachbarten Moduls 2a bzw. 2b, 2c senden, wobei der jeweilige Sender 8 und/oder Empfänger 10 dazu entsprechend ausgestaltet sind. Damit kann der Sender 8 der Steuerungseinheit 20 das Selektionssignal an den Empfänger 10 des benachbarten Moduls 2a senden. Entsprechendes gilt für die benachbarten Module 2a und 2b. Hier kann der Sender 8 des Moduls 2a ein Selektionssignal an den Empfänger 10 des Moduls 2b senden. Entsprechendes gilt für die weiteren benachbarten Module, also beispielsweise für die Module 2b und 2c. Damit wird verhindert, dass das Selektionssignal ungewollt ein Modul 2a, 2b, 2c überspringt. Mittels der Steuerungseinheit 20 und/oder der Module 2a, 2b, 2c kann eine Signalübertragungskette; insbesondere nach Art einer Daisy-Chain, ausgebildet sein, wobei mittels der jeweiligen Selektions-Schnittstelle darüber entschieden werden kann, ob ein Selektionssignal an ein benachbartes Modul 2a, 2b, 2c weitergeleitet wird.

In Fig. 2 sind beispielhafte Signalzustände über die Zeit t aufgetragen dargestellt. Das Bezugszeichen 18 steht repräsentativ für den Parallelbus 18 und die Bezugszeichen A₁, A₂ und A₃ fur die jeweils zu übermittelnden Parallelbus-Adressen. Die Bezugszeichen 20 sowie 2a, 2b und 2c stehen symbolisch für die Steuerungseinheit 20 bzw. für die jeweiligen Module 2a, 2b, 2c. Rechts daneben sind jeweils Rechtecksignale dargestellt. Die größeren der Rechtecksignale repräsentieren jeweils den sogenannten "High-Pegel" und die kleineren Rechtecksignale jeweils einen "Low-Pegel", Die Signalpegel entsprechen den jeweiligen Signalpegeln der Sender 8 der zugehörigen Steuerungseinheit 20 bzw. der Module 2a, 2b, 2c. Zum Zeitpunkt T₀ weisen alle Sender 8 den High-Pegel auf. Soll nun die Steuerungseinheit 20 dem Modul 2a die Adresse A₁ vergeben, so wird das Selektionssignal, hier also der Low-Pegel, des Senders 8 der Steuerungseinheit 20 an den Empfänger 10 des Moduls 2a gesendet. In diesem Fall stellt das Modul 2a das Zielmodul 5 dar. Hierzu korrespondiert der Zeitpunkt T₁. Gleichzeitig oder danach wird mittels der Parallelbus-Schnittstelle 4 der Steuerungseinheit 20 die Parallelbus-Adresse A₁ versendet. Durch den Empfang des Selektionssignals, hier also der Low-Pegel, ist der Adressierungsmodus des Moduls 2a aktiviert, so dass das Modul 2a die Parallelbus-Adresse A₁ empfängt und diese als die eigene Parallelbus-Adresse speichert. Zwar können auch die weiteren Module 2b, 2c die Parallelbus-Adresse A₁ empfangen, jedoch empfangen deren Empfänger 10 nicht das Selektionssignal, hier also den Low-Pegel, so dass deren jeweiliger Adressierungsmodus nicht aktiviert ist und die Adresse A₁ in den Modulen 2b, 2c nicht als deren Parallelbus-Adresse gespeichert wird. Hat das Modul 2a die empfangene Parallelbus-Adresse A₁ als die eigene Parallelbus-Adresse gespeichert, kann das entsprechende Modul 2a ein Bestätigungstelegramm (insbesondere Quittierungssignal) an die Steuerungseinheit 20 senden. Dies erfolgt bevorzugt mittels der jeweiligen Parallelbus-Schnittstelle 4 und dem Parallelbus 18. Das Bestätigungstelegramm kann dabei die bereits zugewiesene Parallelbus-Adresse A₁ umfassen. Die Steuerungseinheit 20 kann zur Überprüfung des Bestätigungstelegramms ausgebildet und/oder eingerichtet sein. Insbesondere kann die Steuerungseinheit 20 prüfen, ob ein Bestätigungstelegramm eine zuletzt vergebene Parallelbus-Adresse A₁ umfasst. Ist dies nicht der Fall, kann die Steuerungseinheit 20 eine entsprechende Fehlermeldung ausgeben. Hat das Modul 2a die im Adressierungsmodus empfangene Parallelbus-Adresse A₁ als ihre eigene Parallelbus-Adresse gespeichert und/oder ein entsprechendes Bestätigungstelegramm versendet, deaktiviert dieses Modul 2a den entsprechenden Adressierungsmodus, Obwohl das Modul 2a danach weiterhin das Selektionssignal, hier den Low-Pegel, empfängt, wird es jedoch nicht erneut den Adressierungsmodus aktivieren. Mit anderen Worten: Nach einer erfolgreichen Adressierung deaktiviert das Modul 2a den Adressierungsmodus. Mit dem Empfang des Bestatigungstelegramms wird anstatt der vorherigen Adresse A₁ eine neue Adresse A₂ mittels der Parallelbus-Schnittstelle 4 der Steuerungseinheit 20 und des Parallelbusses 18 versandt. Die neue Adresse A₂ kann sich dabei von der vorherigen Adresse A₁ unterscheiden. Es ist jedoch auch möglich, dass sich die Adressen A₁ und A₂ gleichen. Dies kann insbesondere dann gewünscht sein, wenn zwei gleichartige Module adressiert werden sollen. Gleichzeitig oder nach dem Versenden des Bestatigungstelegramms leitet das Modul 2a das Selektionssignal (Low-Pegel) mittels des zu diesem Modul 2a zugehörigen Senders 8 weiter bzw. versendet das Selektionssignal. Von nun an ist nicht mehr das Modul 2a, sondern das Modul 2b das Zielmodul 5'. Mit dem deaktivieren von dem Aktivierungsmodus wird also ein benachbartes Modul als neues Zielmodul bestimmt. Hierzu korrespondiert der Zeitpunkt T₂ in Fig. 2. Der Empfänger 10 des benachbarten Moduls 2b empfängt dieses Selektionssignal (Low-Pegel), so dass der Adressierungsmodus dieses Moduls aktiviert wird. Damit kann das Modu12b die von der Steuerungseinheit 20 versandte Parallelbus-Adresse A₂ empfangen und als die eigene Parallelbus-Adresse speichern. Hat das Modul 2b die empfangene Adresse A₂ als die eigene Adresse gespeichert, deaktiviert dieses Modul 2b ihren Adressierungsmodus, sendet ein entsprechendes Bestätigungstelegramm und leitet das Selektionssignal (Low-Pegel) weiter bzw. sendet das Selektionssignal. Damit ist nicht mehr das Modul 2b sondern das Modul 2c das neue Zielmodul 5". Der Ablauf entspricht hierbei dem bereits zu dem vorangegangenen Modul 2a beschriebenen Ablauf. Auf diese Weise können mehreren nebeneinander angeordneten Modulen 2a, 2b, 2c auf überraschend einfache und sichere Weise Parallelbus-Adressen zugewiesen werden.

Die in Fig. 1 a dargestellten Module 2a, 2b und 2c entsprechen den Modulen aus Fig. 1, wobei Fig. 1a ein weiteres Modul 2, nämlich das Anfangsmodul 3, aufweist, das ebenfalls mit dem Parallelbus 18 verbunden ist. Abweichend von der Steuerungseinheit 20, wie sie in Fig. 1 dargestellt ist, weist die Steuerungseinheit 20 aus Fig. 1a keine Selektionssehnittstelle auf. Dies ist auch nicht notwendig, da das Anfangsmodul 3 den zugehörigen Aktivierungsmodus auch ohne ein Selektionssignal der Steuerungseinheit 20 aktivierten kann. Das Anfangsmodul 3 kann den zugehörigen Adressierungsmodus automatisch beim Befestigen auf der Modulaufnahme oder durch ein Betätigen eines entsprechenden Schalters des Anfangsmoduls aktivieren. Sofern das Anfangsmodul 3 eine Selektionsschnittstelle mit einem Empfänger aufweisen sollte, ist es möglich, dass das Anfangsmodul 3 den entsprechenden Aktivierungsmodus durch den Empfang eines "Low-Pegels" aktiviert. Dieser kann beispielsweise dadurch entstehen, dass kein Licht auf den Empfänger trifft. Dies kann auch durch ein Verdecken des entsprechenden Empfängers der Selektionsschnittstelle erfolgen. Sofern der Aktivierungsmodus durch einen "High-Pegel" oder ein anders bestimmtes Signal aktiviert wird, kann dies beispielsweise dadurch erfolgen, dass dem Empfänger der Selektionsschnittstelle des Anfangsmoduls 3 ein entsprechendes Selektionssignal durch eine mobile Aktivierungseinheit übermittelt wird. Somit wird zunächst dem Anfangsmodul 3 eine Parallelbus-Adresse zugewiesen. Nach der erfolgreichen Zuweisung deaktiviert das Anfangsmodul den zugehörigen Adressiemngsmodus und sendet ein Selektionssignal an das Zielmodul 5, damit dieses den zugehörigen Adressierungsmodus aktiviert.

Nach der Adressierung des Anfangsmoduls 3 bzw. jedes weiteren Moduls 2 erfolgt die Kommunikation zwischen der Steuerungseinheit 20 und den (bereits adressierten) Modulen 2 mittels des Parallelbusses 18.

Zusammenfassend kann sich eine bevorzugte Ausgestaltung des Verfahrens dadurch auszeichnen, dass das Zielmodul 5 die empfangene Parallelbus-Adresse als die eigene Parallelbus Adresse speichert, den Adressierungsmodus deaktiviert und das Selektionssignals mittels der zugehörigen Selektionsschnittstelle an ein benachbartes Modul 2b als neues Zielmodul 5' überträgt,

Entsprechend zu dem vorangegangenen Beispiel können das Verfahren, das Modul 2 und/oder das System 16 ausgestaltet sein.

Eine vorteilhafte Ausgestaltung des Verfahrens zeichnet sich dadurch aus, dass die Steuerungseinheit 20 mittels ihrer Parallelbus-Schnittstelle 4 und eines damit verbundenen Parallelbusses 18 eine Parallelbus-Adresse sendet. Des Weiteren kann das Verfahren dazu ausgestaltet sein, dass das Modul 2 im Adressierungsmodus die von der Steuerungseinheit 20 versandte Parallelbus-Adresse mittels der zugehörigen Parallelbus-Schnittstelle 6 empfängt.

Eine vorteilhafte Ausgestaltung der Erfindung sieht vor, dass der Sender 8 der Selektions-Schnittstelle 6 vorsprungsfrei an einer Seitenwand 14 des Moduls 2 angeordnet ist, und/oder dass der Empfänger 10 der Selektions-Schnittstelle 6 vorsprungsfrei an einer weiteren Seitenwand 14 des Moduls 2 angeordnet ist. Wie in Fig. 1 dargestellt, sind der Sender 8 und der Empfänger 10 der Selektions-Schnittstelle 6 bevorzugt an gegenüberliegenden Seitenwänden 14 des Moduls 2 angeordnet. Dazu kann der Sender 8 und/oder der Empfänger 10 der Selektions-Schnittstelle 6 integraler Bestandteil der jeweiligen Seitenwand 14 sein. Mit anderen Worten: Der Sender 8 und/oder der Empfänger 10 können in die jeweilige Seitenwand 14 des Moduls 2 integriert sein. Mit "an einer Seitenwand" kann jedoch auch gemeint sein, dass der Sender 8 und/oder der Empfänger 10 in der Nähe der jeweiligen Seitenwand 14 angeordnet ist. So kann der Sender 8 und/oder der Empfänger 10 von der jeweiligen Seitenwand 14 maximal 2 cm, bevorzugt maximal 1 cm, besonders bevorzugt maximal 5 mm von der jeweiligen Seitenwand 14 beabstandet sein. Werden nun mehrere Module 2 nebeneinander angeordnet, so kann dank dieser vorteilhaften Ausgestaltung ein Selektionssignal besonders energiesparsam von Modul zu Modul übertragen werden. Dank dieser vorteilhaften Ausgestaltung ist es des Weiteren möglich, das Selektionssignal überraschend zielsicher zu versenden. Sendet beispielsweise der Sender 8 eines ersten Moduls 2a als Selektionssignal Licht mit einer bestimmten Intensität aus, so trifft dieses Licht zunächst auf das benachbarte, zweite Modul 2b. Der Empfänger 10 dieses zweiten Moduls 2b empfängt dieses Licht als Selektionssignal. Das Modul 2b verspent jedoch den ungehinderten Weg des Lichts zu einem weiter entfernten Modul 2c. In entsprechender Weise versperrt das erste Modul 2a einen Übertragungsweg des Selektionssignals zwischen der Steuerungseinheit 20 und dem zweiten Modul 2b. Durch die vorteilhafte Ausgestaltung des Moduls ist somit sichergestellt, dass das Selektionssignal nur von Modul zu Modul bzw. von der Steuerungseinheit zu einem (Ziel-)Modul übertragen wird. Mit anderen Worten: Die Module 2 können mittels ihrer jeweiligen Selektions-Schnittstelle nach Art einer Daisy-Chain oder in einer Daisy-Chain angeordnet sein. Ein entsprechendes System 16 ist bevorzugt in der Weise ausgestaltet, dass die Steuerungseinheit 20 und das mindestens eine Modul 2 mittels ihrer jeweiligen Selektions-Schnittstelle nach Art einer Daisy-Chain und/oder in einer Daisy-Chain miteinander verbunden und/oder gekoppelt sind. Die Daisy-Chain hat bevorzugt eine lineare Topologie.

Eine vorteilhafte Ausgestaltung der Erfindung zeichnet sich dadurch aus, dass das Selektionssignal bei benachbarten Modulen 2a, 2b bzw. 2b, 2c drahtlos von Modul zu Modul an das Zielmodul 5" übertragen wird, wobei die Selektions-Schnittstellen 6 der entsprechenden oder sendenden Module 2a, 2b jeweils einen Sender 8 zum Senden des Selektionssignals aufweisen. Da die Steuerungseinheit 20 auch von einem Modul 2, 2b, 2c gebildet werden kann, oder von einem Modul 2, 2b, 2c umfasst sein kann, gilt dies in entsprechender Weise auch für die Übertragung zwischen der Steuerungseinheit 20 und einem Modul 2. Mit benachbarten Modulen sind in diesem Sinne bevorzugt zwei direkt nebeneinander angeordnete Module 2, 2b gemeint. Um das Selektionssignal somit zielsicher zu versenden, ist hierzu keine spezielle Adressierung notwendig. Mit anderen Worten kann die Übertragung des Selektionssignals adressierungsfrei erfolgen. Die Selektions-Schnittstelle 6 bzw. die entsprechende Übertragung des Selektionssignals ist somit überraschend einfach und komfortabel.

Um eine möglichst hohe Übertragungsqualität zu gewährleisten, können der Sender 8 und der Empfänger 10 einer Selektions-Schnittstelle 6 korrespondierend zueinander ausgestaltet sein. Somit wird auf einfache Weise sichergestellt, dass ein von einem Sender 8 eines ersten Moduls 2a versandtes Selektionssignal von einem Empfänger 10 eines zweiten Moduls 2b auch korrekt empfangen und/oder entsprechend ausgewertet werden kann. Weist beispielsweise der Sender 8 eine Lichtquelle auf, so weist der Emplänger 10 bevorzugt einen entsprechenden Lichtsensor auf, Mehrere Module, die jeweils eine entsprechende Selektions-Schnittstelle 6 aufweisen, können ein Selektionssignal mit einer hohen Übertragungsqualität von Modul zu Modul übertragen.

Eine vorteilhafte Ausgestaltung des Moduls sieht vor, dass eine Wirkrichtung 24 des Senders 8 und eine Empfangsrichtung 26 des Empfängers 10 korrespondierend zueinander ausgestaltet und/oder ausgerichtet sind. Die Wirkrichtung 24 und die Empfangsrichtung 26 können parallel zueinander ausgerichtet sein. Des Weiteren können der Sender 8 eines ersten Moduls 2a und der Empfänger 10 eines zweiten Moduls 2b jeweils koaxial zu einer gemeinsamen Achse 28 ausgestaltet und/oder ausgerichtet sein. Entsprechendes ist für die Wirkrichtung 24 und die Empfangsrichtung 26 bevorzugt. Zusammenfassend können eine Wirkrichtung 24 des Senders 8 und eine Empfangsrichtung 26 des Empfängers 10 in der Weise korrespondierend zueinander ausgestaltet und/oder ausgerichtet sein, so dass der Empfänger 10 des Moduls 2b ein Selektionssignal des Senders 8 eines weiteren, insbesondere voran geordneten, Moduls 2a empfangen kann. Dank dieser Ausgestaltung kann eine zielsichere Übertragung des Selektionssignals gewährleistet werden und/oder erhöht werden. Denn ein von einem Sender 8 eines ersten Moduls 2a versendetes Selektionssignal kann auch sicher von dem Empfänger 10 eines zweiten Moduls 2b empfangen werden. Durch die korrespondierende Ausgestaltung der Wirkrichtung 24 und der Empfangsrichtung 26 wird die Gefahr deutlich verringert oder sogar ausgeschlossen, dass ein Selektionssignal "an dem Empfänger 10 vorbei gesendet wird". Außerdem zeichnet sich die vorteilhafte Ausgestaltung durch einen passiven Schutz gegen Störsignale aus. Denn durch die Empfangsrichtung 26 des Empfängers ist ein Bereich deutlich eingeschränkt, aus dem ein Selektionssignal überhaupt empfangen werden kann. Ein Signal, insbesondere Störsignal, das aus einer von der Empfangsrichtung 26 abweichenden Richtung 30 auf die Seitenwand 14 triftt, an der der entsprechende Empfänger 10 angeordnet ist, erreicht diesen Empfänger 10 bevorzugt nicht oder kann von diesem als ein Störsignal bzw. als ein Signal aus einer von der Empfangsrichtung 26 abweichenden Richtung identifiziert werden. Die entsprechende Identifizierung kann dabei durch den Empfänger 10 selbst oder durch eine mit dem Empfänger 10 verbundene Identifikationseinheit (nicht dargestellt) erfolgen. Weist der Sender 8 beispielsweise eine von der entsprechenden Seitenwand 14 nach innen versetzte Lichtquelle 32 auf, deren Licht durch einen Schacht 34 aus der entsprechenden Seitenwand 14 in Wirkrichtung 24 austreten kann, und weist ein benachbartes Modul 2b einen Schacht 36 auf, durch den das Licht des Senders 8 auf einen Lichtsensor 38 des Empfängers 10 treffen kann, wobei die Lichtquelle 32, die Schächte 34, 36 und der Lichtsensor 38 koaxial zu einer gemeinsamen optischen Achse 28 ausgerichtet sind, ist eine sichere und zielgerichtete Übertragung des Selektionssignals möglich. Trifft nun beispielsweise Umgebungslicht 30 in einer von der Wirkrichtung 24 und/oder Empfangsrichtung 26 abweichenden Richtung 30 auf den Schacht 36 des Moduls 2b, so wird dieses den Lichtsensor 38 des Empfängers 10 zumeist nicht oder bevorzugt nur mit einer sehr geringen Intensität erreichen. Somit bietet die vorteilhafte Ausgestaltung des Moduls 2b zugleich eine passive Störentkopplung. Das erfindungsgemäße Verfahren kann korrespondierend ausgestaltet sein.

Eine vorteilhafte Ausgestaltung des Verfahrens zeichnet sich dadurch aus, dass der Sender 8 der jeweiligen Selektions-Schnittstelle 6 eines der Module 2a das Selektionssignal seitlich in Richtung eines benachbarten Moduls 2b aussendet. Außerdem ist es bevorzugt, dass der Empfänger 10 der jeweiligen Selektions-Schnittstelle eines der Module das Selektionssignal seitlich aus einer Richtung eines benachbarten Moduls oder aus Richtung der Steuerungseinheit 20 empfängt. Für diese vorteilhaften Ausgestaltungen des Verfahrens gelten sinngemäß die zuvor genannten Vorteile der zweckmäßigen Weiterbildung des Moduls bzw. des Systems, das ein derartiges Modul aufweist.

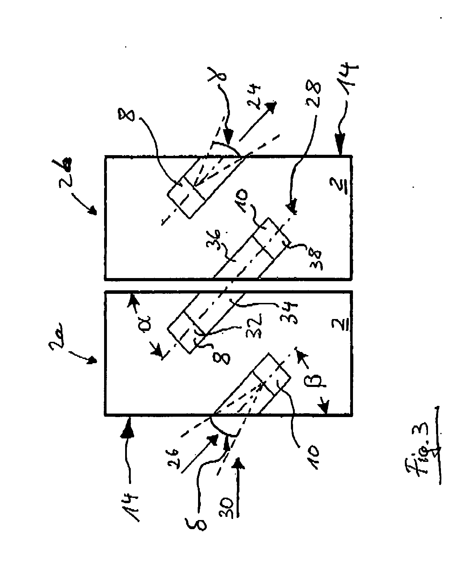

Eine vorteilhafte Weiterbildung des Moduls 2a, wie es auch in Fig. 3 dargestellt ist, zeichnet sich dadurch aus, dass eine Wirkrichtung 24 des Senders 8 in einem Übertragungswinkel α zu der entsprechenden Seitenwand 14 des Moduls 2a ausgerichtet ist, und/oder dass eine Empfangsrichtung 26 des Empfängers 10 in dem (gleichen) Übertragungswinkel β (α = β) zu der entsprechenden Seitenwand 14 des Moduls 2a ausgerichtet ist. Mit dem Übertragungswinkel α, β ist bevorzugt der spitze oder rechte Winkel zwischen der Wirkrichtung 24 bzw. Empfangsrichtung 26 und der dazu jeweils entsprechenden Seitenwand 14 des Moduls 2a gemeint. Mittels übereinstimmender Übertragungswinkel α, β kann auf besonders einfache Weise sichergestellt werden, dass ein Selektionssignal mittels der jeweiligen Selektions-Schnittstelle 6 von direkt benachbarten Modulen 2a, 2b zielsicher übertragbar ist. In analoger Weise gelten des Weiteren die aus dem vorangegangenen Abschnitt erläuterten Vorteile. Der Übertragungswinkel α, β ist bevorzugt ein Winkel zwischen 5° und 90°, insbesondere 90°, und besonders bevorzugt zwischen 30° und 60°. Außerdem kann Dank der aufeinander angepassten Übertragungswinkel α, β der Abstand von zwei benachbarten Modulen 2a, 2b vorgegeben werden, der eine zuverlässige Übertragung des Selektionssignals ermöglicht. Wird der vorgegebene Abstand nicht eingehalten, sind die Wirkrichtung 24 und die Empfangsrichtung 26 ebenfalls beabstandet und parallel zueinander ausgerichtet. Die Wirkrichtung 24 und die Empfangsrichtung 26 bilden deshalb auch keine gemeinsame Achse, so dass eine Übertragung des Selektionssignals allenfalls sehr gestört oder gar nicht stattfinden kann. Der Abstand zwischen den Modulen 2a, 2b kann an die Randbedingungen angepasst sein. Benötigen die Module 2a, 2b eine besonders große Kühlfläche, so ist beispielsweise ein entsprechend großer Abstand zu wählen. Dank der kontaktlosen, galvanikfreien und/oder drahtlosen Übertragung des Selektionssignals ist ein entsprechender Abstand möglich. Werden die Module 2a, 2b hingegen in einem Bereich mit hohem Fremdlicht oder anderen Störungsquellen angeordnet, so kann der Abstand zwischen den Modulen entsprechend klein gewählt werden. Insbesondere kann ein direkter seitlicher Kontakt zwischen den Modulen vorgesehen sein. Eine derartige Ausgestaltung ist darüber hinaus auch sehr kompakt.

In einer vorteilhaften Ausgestaltung ist ein Messbereich 8 des Empfängers 10 und/oder ein Sendebereich γ des Senders 8 jeweils auf einen Winkelbereich von -20° bis +20° um den entsprechenden Übertragungswinkel α bzw. β begrenzt. Der Messbereich δ des Empfängers 10 korrespondiert bevorzugt zu einem "Toleranzbereich", aus dem der Empfänger 10 das Selektionssignal empfangen kann. Entsprechendes gilt für den Sendebereich des Senders 8, Damit ist es möglich, eine Selektions-Schnittstelle besonders preiswert herzustellen. Denn in der Praxis ist es nur mit hohem Aufwand und entsprechenden Kosten möglich, hoch präzise Sender 8 bzw. Empfänger 10 herzustellen. Mit der entsprechenden Empfangsrichtung 26 bzw. Wirkrichtung 24 ist bevorzugt jeweils eine Richtung gemeint, die zumindest im Wesentlichen dazu ausgerichtet ist. Bevorzugt soll hierbei eine aus dem Stand der Technik übliche Toleranz berücksichtigt sein, deren Grenze durch den Messbereich δ bzw. Sendebereich γ begrenzt sein können.

Eine weitere vorteilhafte Ausgestaltung der Erfindung wird im Folgenden erneut unter Zuhilfenahme der Fig. 1 erläutert. Hierbei soll auf das zuvor eingeführte System 16 mit mindestens einem erfindungsgemäßen Modul 2 in Signalverbindung 18 mit der Steuerungseinheit 20 Bezug genommen werden. Hierzu wurde ebenfalls zuvor erläutert, dass derartige Systeme 16 als Brandfallzentrale, insbesondere als Brandmelderzentrale, Löschsteuerungszentrale, Gefahrenmelderzentrale und/oder Steuerungseinheit zur Ansteuerung von Löschanlagen, ausgestaltet sein können. Eine derartige Brandmelderzentrale kann eine Mehrzahl von Detektoren und/oder Aktuatoren aufweisen. Um die Übersichtlichkeit einer derartigen Brandmelderzentrale, insbesondere bei der Installation und/oder der Wartung, zu gewährleisten, zeichnet sich eine vorteilhafte Ausgestaltung des Systems 16 bzw. der Brandmelderzentrale durch gruppierte Module 2 aus. So kann beispielsweise eine Gruppe von Modulen den Detektoren zugeordnet sein. Eine andere Gruppe von Modulen kann beispielsweise den Aktuatoren, insbesondere einer Brandmelderzentrale, zugeordnet sein. Um mittels einer einzigen Steuerungseinheit 20 allen Modulen 2a, 2b, 2c jeweils eine Parallelbus-Adresse zuordnen zu können, ist es von Vorteil, die Kommunikation zwischen den einzelnen Selektions-Schnittstellen 6 möglichst störungsfrei sicherzustellen.

Eine vorteilhafte Ausgestaltung des Systems 16 zeichnet sich dadurch aus, dass die Module 2a, 2b, 2c oder eine Gruppe der Module 2a, 2b nacheinander und/oder jeweils aneinandergrenzend auf der Modulaufnahme befestigt sind, wobei die Parallelbus-Schnittstelle 4 der Module 2a, 2b, 2c mit dem Parallelbus 18 verbunden sind. Dank dieser Ausgestaltung ist das Selektionssignal besonders zielsicher und/oder besonders robust gegenüber Störungen von Modul zu Modul übertragbar. Sind zwei Module 2b, 2c nicht direkt nebeneinander angeordnet oder nicht jeweils aneinandergrenzend auf der Modulaufnahme befestigt, so besteht die Gefahr, dass das Selektionssignal nicht störungsfrei und/oder nicht zielsicher zwischen den Modulen 2b, 2c übertragen wird. Eine vorteilhafte Weiterentwicklung zeichnet sich deshalb dadurch aus, dass das System 16 ein Selektionssignal-Überbrückungsmittel 40 aufweist, das zwischen oder neben zwei voneinander beabstandeten Modulen 2b, 2c angeordnet ist. Mit dem Selektionssignal-Überbrückungsmittel 40 ist bevorzugt ein Mittel gemeint, das zum, insbesondere störungsfreien, Übertragen des Selektionssignals eingerichtet und/oder ausgebildet ist. Beispielsweise ist das Selektionssignal-Überbrückungsmittel 40 ein optischer Leiter, wie beispielsweise ein Glasfaserkabel. Eine vorteilhafte Ausgestaltung des Selektionssignal-Überbrückungsmittels 40 weist einen Empfänger 42 zum Empfang eines Selektionssignals und/oder einen Sender 44 zum Senden des Selektionssignals auf. Der Empfänger 42 und/oder der Sender 44 können in analoger Weise zu dem Empfänger 10 bzw. Sender 8 einer Selektions-Schnittstelle 6 eines Moduls 2 eingerichtet und/oder ausgestaltet sein. Dank des Selektionssignal-Überbrückungsmittels 40 ist es möglich, auch den Adressierungsmodus eines weiter entfernten Moduls 2c, das insbesondere nicht an ein vorangeordnetes Modul 2b grenzt, zu aktivieren und oder dem Modul 2c mittels der, insbesondere zentralen, Steuerungseinheit 20 eine Parallelbus-Adresse zuzuordnen.

Grundsätzlich kann das Selektionssignal-Überbrückungsmittel 40 auch zwischen der Steuerungseinheit 20 und einem Modul 2a angeordnet sein. Eine bevorzugte Ausgestaltung des Systems zeichnet sich jedoch dadurch aus, dass eines der Module 2a seitlich an der Steuerungseinheit 20 grenzend angeordnet ist. Hier ist ein Selektionssignal-Überbrückungsmittel 40 nicht notwendig.

Aus dem Stand der Technik sind unterschiedlichste Modulaufnahmen bekannt. Eine dieser Modulaufnahmen ist eine Hutschiene mit integriertem Parallelbus 18. Eine zweckmäßige Ausgestaltung des Moduls 2 zeichnet sich deshalb dadurch aus, das die Parallelbus-Schnittstelle 4 an der Bodenwand 12 des Moduls 2 angeordnet ist. An der Bodenwand 12 ist auch das Schnellbefestigungsmittel zur Befestigung des Moduls 2 auf der Modulaufnahme angeordnet. Somit kann beim Befestigen des Moduls 2 auf der Modulaufnahme die Verbindung zu dem Parallelbus 18 hergestellt werden. In analoger Weise zu dem Parallelbus 18 kann die Modulaufnahme mindestens ein oder auch eine Mehrzahl von Selektionssignal-Überbrückungsmitteln 40 aufweisen. Eine dazu entsprechend vorteilhafte Ausgestaltung des Moduls 2 zeichnet sich dadurch aus, dass der Sender 8 und/oder der Empfänger 10 der Selektions-Schnittstelle an der Bodenwand 12 des Moduls 2 angeordnet ist. Der Empfänger 42 bzw. der Sender 44 eines von einer Modulaufnahme umfassten Selektionssignal-Überbrückungsmittels 40 können dazu korrespondierend ausgestaltet und/oder ausgerichtet sein, so dass ein Selektionssignal von Modul zu Modul übertragbar ist.

Gesondert zu dem in den vorangegangenen Absätzen erläuterten (ersten) Ausführungsbeispiel wird in den folgenden Absätzen ein weiteres alternatives, zweites Ausführungsbeispiel zu dem Modul, dem System bzw. dem Verfahren erläutert, die jeweils auch auf der erfindungsgemäße Idee beruhen.

Das vorliegende zweite Ausführungsbeispiel betrifft eine Einrichtung zum Adressieren von Modulen auf einer Hutschiene durch eine zentrale Steuerung.

In einigen Bereich der Technik werden häufig Module eingesetzt, die verschiedene Funktionseinheiten enthalten. Je nach Ausbau einer Anlage sind verschiedene Arten und/oder beliebige Anzahle von Modulen erforderlich. Die Module haben häufig spezielle Aufgaben wie z.B. Akquirierung und Verarbeitung von Signalen. Diese Signale können z.B. Signale von Lichtschranken, Winkelgebern oder Füllstandsensoren sein. Andere Modultypen können beispielsweise Relais enthalten. Die Module können häufig auf einer genormten Tragschiene eingerastet werden. Für die elektrische Verbindung der Module untereinander kann ein Verbinder in die Hutschiene eingelassen sein, wie z.B. der "InRailBus" @ der Firma Dold. Andere Systeme stellen eine Verbindung der Module untereinander über seitlich angebrachte Stecksysteme her, wie z.B. Gehäuse der Modulserie "ME" @ der Firma Phoenix Contact.

Die zentrale Steuerung wird häufig durch ein Kleinrechnersystem übernommen, das bevorzugt in einem Modul enthalten ist, wie z.B. die Hutschienen IPCs (Industrie Personal Computer) der Firma Beckhoff Automation. Derartige Anordnungen sind für speicherprogrammierbare Steuerungen typisch, wie sie vielfach in der Industrie eingesetzt werden.

Die Datenkommunikation findet häufig über Bussysteme statt, wie z.B. dem CAN-Bus (Controller Area Network). Für eine einwandfreie Datenkommunikation kann für die Module und die zentrale Steuerung eine eindeutige Adresse nötig sein. Für die Vergabe der Adresse sind verschiedene Verfahren bekannt. Bei CAN-Modulen werden häufig Codierschalter verwendet, mit der die Adresse an jedem Modul manuell eingestellt werden kann. Wird eine falsche Adresse eingestellt, eine vorhandene Adresse fälschlicherweise geändert, oder Adressen doppelt vergeben, kommt es zu Kommunikationsfehlem und ein bestimmungsgemäßer Anlagenbetrieb ist nicht möglich.

Es ist bereits ein Adressvergabeverfahren bekannt, das eine Adresse seriell durch eine Verbindungsleitung zwischen den Modulen weiterleitet. Das Verfahren benötigt jedoch einen elektrischen Kontakt zwischen benachbarten Modulen. Bei einem Bussystem, das lediglich parallel geschaltete Module ermöglicht, kann das Verfahren nicht angewendet werden.

Hersteller von Kleinserien sind auf am Markt verfügbare Gehäuse und Verbindungssysteme angewiesen. Derzeit ist jedoch kein Adressierungssystem für ein Modulgehäuse bekannt, das ohne seitliche galvanische Kontakte auskommt.

Zweck dieses zweiten Ausführungsbeispiels ist die Bereitstellung einer Vorrichtung zur Adressierung von Modulen mit einem Parallelbus. Die notwendige Modul-zu-Modul-Verbindung wird nicht über eine galvanische Verbindung, sondern optisch realisiert. Dabei werden bevorzugt keine Daten über die Verbindung übertragen, sondern lediglich ein HIGH/LOW Signal mit der Bedeutung "Adresse zuweisen". Die Adresse selbst gelangt bevorzugt nicht über diese Verbindung, sondern über den Datenbus, der ohnehin für die Kommunikation benutzt wird. Das HIGH/LOW Signal kann über eine optische Verbindung, bestehend aus einer LED (Light Emitting Diode) und einer Photodiode realisiert werden. Bevorzugt bedeutet die Aktivierung der LED, dass das aktivierende Modul noch keine Adresse zugewiesen bekommen hat. In diesem Fall kann es vorgesehen sein, dass das folgende Modul dadurch nicht auf Adresszuweisungen über den Bus reagiert. Erst wenn die LED ausgeschaltet ist, kann das folgende Modul auf eine Adresszuweisung reagieren, die auf dem Bus übermittelte Adresse akzeptieren und seine LED löschen. Durch dieses für das zweite Ausführungsbeispiel beschriebene Verfahren können alle Module nacheinander in ihrer Reihenfolge korrekt adressiert werden.

Das zweite Ausführungsbeispiel ermöglicht somit eine besonders einfache und sichere Adressierung von einem Modul und macht darüber hinaus die Nutzung eines Verbindungssystems möglich, das über keine seitlichen galvanischen Kontakte verfügt, sondern ausschließlich über rückwärtige parallelgeschaltete Kontakte.

Gemäß einer Weiterbildung des zweiten Ausführungsbeispiels können größere Abstände zwischen den Modulen auch zu einer anderen Hutschiene mittels eines Lichtleiters vorgenommen werden. Eine weitere Möglichkeit stellt die Verbindung über entsprechende Umsetzer optisch/galvanisch und umgekehrt mit einer dazwischen liegenden galvanischen Verbindung dar. Durch diese Ausgestaltung lassen sich größere Anordnungen adressieren, die auf mehreren Hutschienen untereinander aufgebaut sind.

Eine weitere Ausgestaltung des zweiten Ausführungsbeispiels wird in den folgenden Absätzen beschrieben:

Auf einer Hutschiene können eine zentrale Steuerung und mehrere Module angeordnet sein. Die Hutschiene enthält insbesondere Stromschienen, die innerhalb der Hutschiene verlaufen können. Alle Module und die zentrale Steuerung können über rückwärtige Kontakte miteinander verbunden sein. Bevorzugt stellt das Stecken der Module, insbesondere gleichzeitig, die elektrische Verbindung über die Kontakte her. Die Einspeisung der Energie erfolgt zumeist über einen Klemmstein aus der Spannungsversorgung über entsprechende Kontakte.

Die Module können mit je einem optischen Empfänger und einem optischen Sender ausgestattet sein. Die Module sind zumeist so zu platzieren, dass der optische Sender in den optischen Empfänger des folgenden Moduls strahlen kann. Längere Distanzen können über einen Lichtleiter überbrückt werden. Wahlweise ist auch eine galvanische Weiterleitung des Signals möglich, wobei der Lichtleiter durch eine elektrische Verbindung ersetzt wird und an seinen Enden mit einem optischen Empfänger und einem optischen Sender ausgerüstet wird.

Das zentrale Steuermodul ist bevorzugt lediglich mit einem optischen Sender ausgestattet, der je nach Protokollimplementation auch entfallen kann. Der optische Sender wird oftmals durch die zentrale Steuerung kontrolliert, die auch den Busverkehr über den Datenbus kontrollieren kann. Der Datenbus wird insbesondere über die Signalschienen geführt. Besonders bevorzugt erhält die zentrale Steuerung vor der Inbetriebnahme von externen Geräten (z.B. Laptop, nicht dargestellt) die Information über Anzahl, Reihenfolge und Art der angeschlossenen Module, wobei diese Informationen oftmals als Konfiguration bezeichnet wird.

Die optischen Sender und Empfänger der Module können dazu über eine Modulsteuerung kontrolliert werden, die bevorzugt auch mit dem Datenbus verbunden ist. Die Modulsteuerung kann ebenfalls mit externen Sensoren und Aktuatoren verbunden sein. Eine weitere Ausführungsform dieses zweiten Ausführungsbeispiels wird anhand der folgenden Schritte 1 bis 13 beispielhaft erläutert. Bevorzugt werden die Schritte 1 bis 13 nacheinander ausgeführt. Grundsätzlich können aber auch beliebige Schritte miteinander kombinierbar sein und/oder beliebige Schritte ausgelassen werden.

### Schritt 1:

Zu Beginn der Adressierung erhalten alle Module von der zentralen Steuerung einen Befehl über die Datenleitungen zur Einnahme des Adressierungsmodus. Die zentrale Steuerung aktiviert ihren optischen Sender.

### Schritt 2:

Die Module löschen ihre eventuell bereits zugewiesene Adresse und aktivieren ebenfalls ihre optischen Sender.

### Schritt 3:

Die zentrale Steuerung kann einen Befehl senden, der alle Module zu einer Überprüfung des empfangenen Signals an ihren optischen Empfängern auffordert und eine Benachrichtigung an die zentrale Steuerung zu senden, falls kein Signal empfangen wird. Dieser Fall würde auf eine Unterbrechung einer optischen Verbindung hinweisen. Eine Lokalisierung der Unterbrechung ist in diesem Stadium ist erschwert, da der Absender der Nachricht noch nicht über eine Adresse verfügt.

### Schritt 4:

Die zentrale Steuerung deaktiviert ihren optischen Sender.

### Schritt 5:

Die zentrale Steuerung legt die Adresse für das erste Modul auf den Adressbus.

### Schritt 6:

Alle Module lesen die Adresse mit, jedoch nur diejenigen Module deren optische Empfänger kein Licht empfangen, übernehmen die Adresse als zugewiesene Adresse für sich. Das ist zunächst das Modul, das direkt neben der zentralen Steuerung montiert ist.

### Schritt 7:

Alle Module, die eine Adresse in Schritt 5 übernommen haben, antworten mit einem Bestätigungstelegramm. Die Arbitrierung wird durch übergeordnete Protokolle übernommen. Das Bestätigungstelegramm enthält bereits die zugewiesene Adresse als Absender.

### Schritt 8:

Die zentrale Steuerung überprüft, ob nur ein Modul antwortet. Anderenfalls wird ein Fehler erkannt.

Schritt 9: Diejenigen Module, die in Schritt 5 die auf den Bus gelegte Adresse übernommen haben, deaktivieren ihren optischen Sender.

### Schritt 10:

Es erfolgt die Wiederholung der Schritte 4 bis 9 für die folgenden Module, wobei jeweils in Schritt 4 die Adresse des zu adressierenden Moduls auf dem Bus über die Signalschienen gesendet wird.

### Schritt 11:

Die zentrale Steuerung versucht probeweise ein weiteres Modul zu adressieren, um zu überprüfen, ob die Anzahl der Module mit der konfigurierten Anzahl übereinstimmt. Erhält die zentrale Steuerung kein Bestätigungstelegramm, stimmt die Anordnung und/oder Anzahl der Module mit der Konfiguration überein.

### Schritt 12:

Weitere Diagnoseschritte können eingesetzt werden, z.B. um eine fehlende optische Verbindung zu lokalisieren.

### Schritt 13:

Die Datenkommunikation zu allen Modulen ist aufgebaut. Es folgen Überprüfungen der korrekten Kommunikation mit jedem einzelnen Modul und eine Überprüfung der konfigurierten Modulart.

### Schritt 14:

Die Module werden in den Kommunikationsmodus geschaltet und können gemäß dem definierten Protokoll verwendet weiden.

## Patentansprüche

1. Modul (2) mit einem Schnellbefestigungsmittel zur Befestigung des Moduls (2) auf einer Modulaufnahme, einer Parallelbus-Schnittstelle (4) zum Senden und/oder Empfangen von Daten, Adressen und/oder Steuersignalen und mit einer Selektions-Schnittstelle (6), wobei die Selektions-Schnittstelle (6) einen Sender (8) zum Senden eines Selektionssignals und/oder einen Empfänger (10) zum Empfang eines Selektionssignals aufweist, wobei das Schnellbefestigungsmittel an der Bodenwand (12) des Moduls (2) angeordnet ist, **dadurch gekennzeichnet, dass** die Seitenwände (14) vorsprungsfrei ausgestaltet sind.

2. Modul (2) nach dem vorangehenden Anspruch, **dadurch gekennzeichnet, dass** die Selektions-Schnittstelle (6) eine drahtlose Schnittstelle ist.

3. Modul (2) nach einem der vorhergehenden Ansprüche, **dadurch gekennzeichnet, dass** der Sender (8) der Selektions-Schnittstelle (6) vorsprungsfrei an einer Seitenwand (14) des Moduls (2) angeordnet ist, und/oder dass der Empfänger (10) der Selektions-Schnittstelle (6) vorsprungsfrei an einer weiteren Seitenwand (14) des Moduls (2) angeordnet ist.

4. Modul (2) nach einem der vorhergehenden Ansprüche 1-2, **dadurch gekennzeichnet, dass** der Sender (8) und/oder der Empfänger (10) der Selektions-Schnittstelle (6) an der Bodenwand (12) des Moduls (2) angeordnet ist.

5. Modul (2) nach einem der vorhergehenden Ansprüche, **dadurch gekennzeichnet, dass** die Parallelbus-Schnittstelle (4) an der Bodenwand (12) des Moduls (2) angeordnet ist.

6. Modul (2) nach einem der vorhergehenden Ansprüche, **dadurch gekennzeichnet, dass** eine Wirkrichtung (24) des Senders (8) und eine Empfangsrichtung (26) des Empfängers (10) korrespondierend zueinander ausgestaltet und/oder ausgerichtet sind, so dass der Empfänger (10) des Moduls (2) ein Selektionssignal eines Senders (8) eines weiteren Moduls (2) nach einem der vorhergehenden Ansprüche empfangen kann.

7. Modul (2) nach einem der vorhergehenden Ansprüche, **dadurch gekennzeichnet, dass** der Sender (8) der Selektions-Schnittstelle (6) eine Lichtquelle, eine induktive Quelle, eine akustische Quelle oder einen mechanischen Stempel aufweist, und/oder dass der Empfänger (10) der Selektions-Schnittstelle (6) einen optischen Sensor, einen Induktionssensor, einen akustischen Sensor oder einen mechanischen Sensor aufweist.

8. Modul (2) nach einem der vorhergehenden Ansprüche, **dadurch gekennzeichnet, dass** der Sender (8) der Selektions-Schniftstelle (6) eine Kodier-Einheit und/oder eine Modulations-Einheit ausweist, und/oder dass der Empfänger (10) der Selektions-Schnittstelle (6) eine Dekodier-Einheit und/oder eine Demodulations-Einheit auf weist.

9. System (16) mit einer Modulaufnahme, einem Parallelbus (18), einer Steuerungseinheit (20), der eine Parallelbus-Schnittstelle (4) zum Senden und/oder Empfangen von Daten, Adressen und/oder Steuersignalen zugeordnet ist, wobei die Parallelbus-Schnittstelle (4) der Steuerungseinheit (20) mit dem Parallelbus (18) verbunden ist, und mindestens einem Modul (2) in Signalverbindung mit der Steuerungseinheit (20),**dadurch gekennzeichnet, dass** jedes der Module (2) nach einem der vorhergehenden Ansprüche 1-8 ausgestaltet ist.

10. System (16) nach dem vorangehenden Anspruch, **dadurch gekennzeichnet, dass** die Module (2) nacheinander und jeweils aneinander grenzend auf der Modulaufnahme befestigt sind, wobei die Parallelbus-Schnittstellen (4) der Module (2) mit dem Parallelbus (18) verbunden sind.

11. System (16) nach einem der vorhergehenden Ansprüche 9-10, **dadurch gekennzeichnet, dass** eines der Module (2) seitlich an die Steuerungseinheit (20) grenzend angeordnet ist, wobei der Steuerungseinheit (20) eine Selektions-Schnittstelle (6) mit einem Sender (8) zum Senden eines Selektionssignals zugeordnet ist.

12. Verfahren zur Vergabe von Parallelbus-Adressen von einer Steuerungseinheit (20) an Module (2), wobei der Steuerungseinheit (20) eine Parallelbus-Schnittstelle (4) zum Senden und/oder Empfangen von Daten, Adressen und/oder Steuersignalen zugeordnet ist, und wobei jedes Modul (2) eine Parallelbus-Schnittstelle (4) zum Senden und/oder Empfangen von Daten, Adressen und/oder Steuersignalen und eine Selektions-Schnittstelle (6) mit einem Sender (8) zum Senden eines Selektionssignals und/oder einem Empfänger (10) zum Empfang eines Selektionssignals aufweist, **dadurch gekennzeichnet, dass**
entweder eines der Module (2) als Anfangsmodul (3) mittels der zugehörigen Selektions-Schnittstelle (6) drahtlos ein Selektionssignal zum Aktivieren eines Adressierungsmodus sendet und ein weiteres der Module (2) als Zielmodul (5) mittels der zugehörigen Selektions-Schnittstelle (6) das Selektionssignal zum Aktivieren des Adressierungsmodus drahtlos empfängt oder
dass der Steuerungseinheit (20) eine Selektions-Schnittstelle (6) mit einem Sender (8) zum Senden eines Selektionssignals zugeordnet ist, die Steuerungseinheit (20) mittels ihrer Selektions-Schnittstelle (6) drahtlos ein Selektionssignal zum Aktivieren eines Adressierungsmodus sendet und eines der Module (2) als Zielmodul (5) mittels der zugehörigen Selektions-Schnittstelle (6) das Selektionssignal zum Aktivieren des Adressierungsmodus drahtlos empfängt.

13. Verfahren nach dem vorangehenden Anspruch, **dadurch gekennzeichnet, dass** das Selektionssignal bei benachbarten Modulen (2) drahtlos von Modul zu Modul an das Zielmodul (5) übertragen wird.

14. Verfahren nach einem der vorhergehenden Ansprüche 12-13, **dadurch gekennzeichnet, dass** der Sender (8) der jeweiligen Selektions-Schnittstelle (6) des Anfangsmoduls (3) oder der Steuerungseinheit (20) und/oder der Modul zu Modul übertragenden Module (2) das Selektionssignal seitlich in Richtung eines benachbarten Moduls (2) aussenden.

15. Verfahren nach einem der vorhergehenden Ansprüche 12-14, **dadurch gekennzeichnet, dass** der Empfänger (10) der jeweiligen Selektions-Schnittstelle (6) der Modul zu Modul übertragenden Module (2) oder des Zielmoduls (5) das Selektionssignal seitlich aus einer Richtung eines benachbarten Moduls (2) oder aus einer Richtung der Steuerungseinheit (20) empfangen.

16. Verfahren nach einem der vorhergehenden Ansprüche 12-15, **dadurch gekennzeichnet, dass** das Zielmodul (5) durch den Empfang des Selektionssignals zum Aktivieren des Adressierungsmodus einen zugehörigen Adressierungsmodus zum Empfang einer Parallelbus-Adresse mittels der zugehörigen Parallelbus-Schnittstelle (4) aktiviert.

17. Verfahren nach dem vorangehenden Anspruch, **dadurch gekennzeichnet, dass** die Steuerungseinheit (20) mittels ihrer Parallelbus-Schnittstelle (4) und eines damit verbundenen Parallelbusses (18) eine Parallelbus-Adresse sendet.

18. Verfahren nach dem vorangehenden Anspruch, **dadurch gekennzeichnet, dass** das Zielmodul (5) im Adressierungsmodus die von der Steuerungseinheit (20) versandte Parallelbus-Adresse mittels der zugehörigen Parallelbus-Schnittstelle (4) empfängt.
